# EUROPEAN PATENT SPECIFICATION

(11) **EP 2 290 701 B1**
(45) Date of publication and mention of the grant of the patent: **11.12.2013**
(21) Application number: 09758387.6
(22) Date of filing: 04.06.2009
(51) Int. Cl.: H01L 31/04, C23C 16/44, H01L 21/205, H01J 37/32

(54) **APPARATUS FOR MANUFACTURING THIN FILM SOLAR CELL**
VORRICHTUNG ZUR HERSTELLUNG EINER DÜNNFILMSOLARZELLE
APPAREIL POUR LA FABRICATION DE CELLULE SOLAIRE EN COUCHES MINCES

(30) Priority: 06.06.2008 JP 2008149935
(43) Date of publication of application: 02.03.2011
(73) Proprietor: Ulvac, Inc., Chigasaki-shi Kanagawa 253-8543 (JP)
(72) Inventor: SHIMIZU Yasuo, Chigasaki-shi Kanagawa 253-8543 (JP); OGATA Hideyuki, Chigasaki-shi Kanagawa 253-8543 (JP); MATSUMOTO Koichi, Chigasaki-shi Kanagawa 253-8543 (JP); NOGUCHI Takafumi, Chigasaki-shi Kanagawa 253-8543 (JP); WAKAMORI Jouji, Chigasaki-shi Kanagawa 253-8543 (JP); OKAYAMA Satohiro, Chigasaki-shi Kanagawa 253-8543 (JP); MORIOKA Yawara, Chigasaki-shi Kanagawa 253-8543 (JP); SUGIYAMA Noriyasu, Chigasaki-shi Kanagawa 253-8543 (JP); SHIGETA Takashi, Chigasaki-shi Kanagawa 253-8543 (JP); KURIHARA Hiroyuki, Chigasaki-shi Kanagawa 253-8543 (JP); HASHIMOTO Masanori, Sammu Chiba 289-1226 (JP); WAKAMATSU Sadatsugu, Sammu Chiba 289-1226 (JP)
(74) Representative: Eisenführ, Speiser & Partner
(86) International application number: PCT/JP2009/060252
(87) International publication number: WO 2009/148120

(56) References cited:
- EP-A1- 1 622 192
- EP-A1- 2 293 342
- DE-A1- 10 352 606
- JP-A- 1 232 717
- JP-A- 5 283 343
- JP-A- 11 330 520
- JP-A- 2002 359 203
- JP-A- 2004 335 601
- JP-A- 2005 158 982
- JP-A- 2008 034 469
- JP-T- 2002 531 695
- US-A- 4 576 830

## Description

### Technical Field

The present invention relates to an apparatus for manufacturing a thin-film solar cell.

### Background Art

Although most current solar cells are of a single crystal Si type and a polycrystal Si type, there are growing concerns about material shortages or the like of Si. Thus, demand has recently been increasing for thin-film solar cells formed with a thin-film Si-layer in which the manufacturing costs are low and the risk of material shortages is low. Moreover, in addition to a conventional thin-film solar cell having only an a-Si (amorphous silicon) layer, demand for tandem-type thin-film solar cells aiming at improvements in photoelectric conversion efficiency by laminating an a-Si-layer and a µc-Si (microcrystalline silicon) layer has recently been increasing.
A plasma-CVD apparatus is often used for film-forming a thin-film Si-layer (semiconductor layer) of the thin-film solar cells. As this type of plasma-CVD apparatus, a single-wafer-type PE-CVD (plasma CVD) apparatus, an in-line type PE-CVD apparatus, a batch-type PE-CVD apparatus, and the like exist.

When the conversion efficiency as a thin-film solar cell is taken into consideration, the µc-Si-layer of the above tandem-type solar cell needs to be film-formed with a film thickness (about 1.5 µm) of about five times larger than the a-Si-layer. Additionally, since the µc-Si-layer needs to be uniformly form of a good microcrystal film, there is also a limit to increasing the film formation rate. Accordingly, in order to compensate for this, productivity is required to improve by virtue of an increase in the number of batches or the like. That is, an apparatus which can realize higher throughput at a low film formation rate is needed.

Additionally, as a CVD apparatus which aims at improvements in productivity and is able to form a film with high precision even on a substrate to be enlarged, there is a vertical CVD apparatus which performs film forming in a state where the film formation face of the substrate is arranged so as to be substantially parallel to the direction of gravitational force. Some of the vertical CVD apparatuses have a carrier (conveying part) in which a pair of supporting walls (holders) for supporting a substrate is vertically provided. The respective supporting walls are arranged so as to be substantially parallel to each other. The carrier moves along the planar direction thereof in a state where the substrate is supported by the respective supporting walls, and makes the substrate enter and exit the film forming chamber. The film forming chamber is provided with a heater for heating each substrate. This heater is disposed between the pair of conveyed substrates. Additionally, high-frequency electrodes (cathodes) are respectively disposed on both side walls of the film forming chamber at the inner surface thereof. By supplying electric power to the high-frequency electrodes, a film forming gas supplied to the film forming chamber is turned into plasma (for example, refer to Patent document D1).
JP 2008 034469 A discloses a plasma device for simultaneously depositing thin films on two substrates arranged on a conveying unit and situated between an electrode acting as a cathode and two heaters. The frames of the carriers act as the anode.
US 4,576,830 A discloses a method and apparatus for continuous plasma CVD deposition an and through a vacuum system, in which box carriers are provided to carry both the substrates and the plasma exciting electrodes through the system.
JP 5 283343 A discloses a double side discharge type plasma CVD device in which electric power supplied from a high frequency power supply generated glow discharge between a power applicating metallic plate and a second electrode. Electric power supplied from a high frequency power supply generates glow discharge between a power applicating metallic plate and a second electrode. Since a grounding metallic plate can be controlled without generating electrical interference mutually.
EP 1 622 192 A1 discloses a substrate transfer device for a thin-film deposition apparatus. In order to positively prevent plasma generated by electrodes from coming into a rear surface of the substrate and to attain cost reduction and improvement in maintenance without providing a mask panel in a deposition chamber with which the whole outer peripheral edge of the substrates is masked, partition panels each with an opening larger than substrate and facing the electrode are arranged on a transfer carriage, a picture-frame-like substrate holder with the substrate fitted thereto being arranged on a side of the partition panel away from the electrode such that the substrate is arranged substantially at a center of the opening of the partition panel and the outer peripheral edge of the substrate holder is masked with the partition panel.
DE 103 52 606 A1 discloses a semiconductor device manufacturing unit in which a chamber is formed so that the inside thereof can be controlled at a vacuum of an arbitrary degree. Anode supports for supporting an anode are placed at the bottom of the internal structure. The anode is made of material having a high electrical conductivity and a high heat resistance. The temperature of the anode is controlled by a heater so as to be in a range of from room temperature to 600° C. A cathode is placed on a cathode support so as to face the anode. The cathode support is attached to an internal structure made of a frame in a rectangular prism from provided within the camber. Citation List

### [Patent Document]

Patent Document 1 Japanese Patent Application, First Publication No. 2002-270600

### Summary of the Invention

### Problems to be Solved by the Invention

In the above-described CVD apparatus, in addition to the film forming chamber, chambers, such as a heating chamber for heating a substrate and an ejecting chamber for taking out a substrate having a film formed on the surfaced to be :film-formed thereof, are required for every film forming process. Moreover, when a film with a multilayer structure is formed on a substrate, a plurality of film forming chambers is required according to film formation of respective layers. In this case, the carrier moves each chamber in a state where the substrate is supported by the respective supporting walls.
When a film is formed on the film formation face of the substrate, the carrier also enters and exits the film forming chamber along with the substrate. For this reason, since the whole carrier is exposed within the film forming chamber, a film will be formed even on the carrier in addition to the film formation face of the substrate.

If a film is formed on the carrier, for example, there is a possibility that the film formed on the carrier may be peeled off during the transfer of the carrier or the like, and this film may adhere to the film formation face of the substrate as reactive by-products (powder). For this reason, a normal film is no longer formed on the film formation face of the substrate to which the reactive by-products (powder) have adhered.

Thus, the present invention has been made in consideration of the above circumstances, and the object thereof is to provide an apparatus for manufacturing a thin-film solar cell which can improve the quality of a film to be formed on the film formation face of a substrate by preventing formation of a film on a conveying part while improving productivity.

### Means for Solving the Problem

The present invention has adopted the followings in order to solve the above problems and achieve the relevant object.
(1) An apparatus for manufacturing a thin film solar cell of the present invention includes a film forming chamber in which a film is formed on a film formation face of a substrate using a CVD method; an electrode unit including a cathode unit having cathodes to which voltages are to be applied are arranged on both sides thereof, and a pair of anodes each of which is arranged to face a different one of the cathodes, respectively, at a separation distance therefrom; a mask for covering a peripheral edge portion of the substrate; and a discharge duct installed around the cathode unit. A film formation space is formed between the cathode unit and the substrate installed on the side of the anode. An evacuation passage is formed between the mask and the cathode unit. The discharge duct and the film formation space are connected together via the evacuation passage. A film forming gas introduced into the film formation space is evacuated from the discharge duct through the evacuation passage. The electrode unit further includes a drive part which makes the anode approach or separate from the cathode, and the mask covers the peripheral edge portion of the substrate by moving the anode holding the substrate toward the cathode, using the drive part. The apparatus further includes a conveying part which conveys the substrate between the anode and the cathode unit. The conveying part has a first holding piece which abuts the film formation face of the substrate, and a second holding piece which abuts the back surface of the substrate. The substrate is held by the first holding piece and the second holding piece. When the anode approaches the cathode unit, the first holding piece separates from the second holding piece. When the anodeseparates from the cathode unit, the first holding piece approaches the second holding piece. When a film is formed on the film formation face of the substrate, the peripheral edge portion of the substrate nearer to the inner peripheral side than the first holding piece of the conveying part is covered with the mask.

According to the apparatus for manufacturing a thin-film solar cell described in the above (1), when a film is formed on the surface to be film-formed of a substrate, a film formation space is formed between the cathode unit and the substrate installed at the anode. Thus, the peripheral edge portion of the substrate can be prevented from being exposed to the film formation space, and a film can be prevented from being formed on the peripheral edge portion of the substrate.
Additionally, since a discharge duct is installed around the cathode unit, a film forming gas (exhaust gas) can be discharged from the periphery of the substrate. For this reason, it is possible to improve evacuation efficiency.
Moreover, for example, reactive by-products (powder) or the like generated when a film is formed on the surface to be film-formed of a substrate can be easily collected by performing evacuation using the discharge duct. In this case, it is possible to make reactive by-products (powder) adhere to and deposit on the inner wall of the discharge duct, thereby evacuating a comparatively clean film forming gas which does not include reactive by-products (powder). Additionally, when the discharge duct is cleaned, the reactive by-products (powder) can be cleaned together. Also, the discharge duct is connected to the film formation space at the evacuation passage formed between the mask and the cathode unit, and the film forming gas is evacuated from the discharge duct through the evacuation passage. The film formation space is formed by the cathode unit and the substrate, and the reactive by-products (powder) and the film forming gas are evacuated by the discharge duct via the evacuation passage from the film formation space. Thus, diffusion of the film forming gas or reactive by-products (powder) to other regions can be limited, and contamination to regions other than the film formation space within the film forming chamber can be reduced. The anode moves in the direction in which the anode approaches or separates from the cathode unit. Thus, the gap between the anode and the cathode unit can be set to be large when a substrate enters and exits the film forming chamber. Meanwhile, when a film is formed on the film formation face of the substrate, the gap between the anode and the cathode unit can be set to be small. For this reason, it is possible to facilitate the entrance and exit of the substrate from the inside of the film forming chamber while improving the quality of the film to be formed, and it is possible to improve productivity. Additionally, with the movement of the anode, the substrate can be easily brought close to or separated from the cathode unit.
Moreover, the peripheral edge portion of the substrate is covered with the mask by moving the anode toward the cathode. This prevents a film from being formed on the peripheral edge portion of the substrate. For this reason, formation of a film on the peripheral edge portion of the substrate can be reliably prevented at low cost, without extensive constitution of the mask.
Additionally, when the mask covers the peripheral edge portion of the substrate, the film forming gas can be kept from spreading into a region where the conveying part (carrier) for a substrate which will be described later or the anode exists.
The substrates are conveyed using the conveying part. Thus, the substrate can be continuously moved between chambers which are set for every film forming process, and productivity can be improved.
Additionally, when a film is formed on the film formation face of a substrate, the mask covers the first holding piece, and spreading of the film forming gas toward the conveying part is limited. Thus, adhesion of a film or reactive by-products to the conveying part can be reduced. For this reason, the cleaning frequency of the conveying part can be decreased. Additionally, for example, the film to be formed on the conveying part can be prevented from being peeled off and adhering to the film formation face of the substrate. For this reason, the quality of a film to be formed on the film formation face of the substrate can be improved.

(2) The cathode may be a shower plate which supplies the film forming gas to the film formation face of the substrate.
In the above (2), it becomes unnecessary to separately provide the cathode and the shower plate, and it is possible to achieve simplification and lower cost of the apparatus for manufacturing a thin-film solar cell. Additionally, the film forming gas can be uniformly introduced into a film forming area (the film formation space) by adopting the shower plate as the cathode, and a high-frequency voltage can be uniformly applied to the film forming area. Therefore, the plasma becomes more uniform and the quality of the film to be formed can be improved.

(3) The space where the film formation space exists, and the space where the conveying part exists may be separated from each other as the mask covers the peripheral edge portion of the substrate.
In the above (3), the film formation space can be prevented from being expanded more than needed. As a result, it becomes unnecessary to discharge the film forming gas wastefully, and it is possible to reduce manufacturing costs.
Additionally, the range where the film forming gas spreads is limited, and formation of a film to an unnecessary range, that is, the outer-edge portion of the substrate or the anode can be prevented. Moreover, since the mask can be separated from the film forming chamber integrally with the electrode unit, cleaning of the mask becomes easier. As a result, the operating rate of the apparatus for manufacturing a thin-film solar cell can be improved.

(4) A temperature control section for adjusting the temperature of the substrate may be built in the anode.
In the above (4), it is possible to efficiently control the temperature of the substrate. Additionally, since it becomes unnecessary to provide a temperature control section separately from the anode, the apparatus for manufacturing a thin-film solar cell can be miniaturized.

### Advantageous Effects of Invention

According to the apparatus for manufacturing a thin-film solar cell described in the above (1), when a film is formed on the film formation face of a substrate, a film formation space is formed between the cathode unit and the substrate installed in the anode. Therefore, the peripheral edge portion of the substrate can be prevented from being exposed to the film formation space, and a film can be prevented from being formed on the peripheral edge portion of the substrate. Additionally, in this film formation space, reactive by-products (powder) and film forming gas are discharged by the discharge duct via the evacuation passage from the film formation space. Therefore, diffusion of the film forming gas or reactive by-products (powder) to regions within other film forming apparatuses from the film formation space can be limited, and contamination in regions other than the film formation space within the film forming chamber can be reduced.
Additionally, reactive by-products (powder) or the like generated when a film is formed on the film formation face of a substrate can be easily collected by performing evacuation using the discharge duct. In this case, it is possible to make reactive by-products (powder) adhere to and deposit on the inner wall of the discharge duct, thereby evacuating a comparatively clean film forming gas which does not include reactive by-products (powder). Moreover when a film is formed on the film formation face of a substrate, the mask covers the first holding piece, and spreading of the film forming gas toward the conveying part is limited. Thus, adhesion of a film or reactive by-products to the conveying part can be reduced. For this reason, the cleaning frequency of the conveying part can be decreased. Additionally, the film to be formed on the conveying part can be prevented from being peeled off and adhering to the film formation face of the substrate. For this reason, the quality of a film to be formed on the film formation face of the substrate can be improved.

### Brief Description of the Drawings

FIG. 1 is a schematic sectional view showing an example of a thin-film solar cell manufactured by an apparatus for manufacturing a thin-film solar cell of the present invention.
FIG 2 is a schematic configuration of an apparatus for manufacturing a thin-film solar cell related to one embodiment of the present invention.
FIG 3A is a perspective view of a film forming chamber of the present embodiment.
FIG 3B is a perspective view when the film forming chamber is seen from a different angle.
FIG 3C is a side view of the film forming chamber.
FIG 4A is a perspective view of an electrode unit of the present embodiment.
FIG 4B is a perspective view when the electrode unit is seen from a different angle.
FIG 4C is a view showing a modification of the electrode unit, and is an exploded perspective view of a part of the electrode unit.
FIG 4D is a partial sectional view of a cathode unit and an anode unit of the electrode unit of the present embodiment.
FIG. 5A is a perspective view of a loading-ejecting chamber of the present embodiment.
FIG. 5B is a perspective view when the loading-ejecting chamber is seen from a different angle.
FIG. 6 is a schematic configuration of a push-pull mechanism of the present embodiment.
FIG. 7A is a perspective view showing a schematic configuration of a substrate replacement chamber of the present embodiment.
FIG. 7B is a front view in Fig. 7A.
FIG. 8 is a perspective view of a substrate storage holder of the present embodiment.
FIG. 9 is a perspective view of a carrier of the present embodiment.
FIG. 10 is an explanatory view (1) showing a process of a method for manufacturing a thin-film cell related to one embodiment of the present invention using the above apparatus for manufacturing a thin-film solar cell.
FIG. 11 is an explanatory view (2) showing the subsequent process of the method for manufacturing a thin-film solar cell.
FIG. 12 is an explanatory view (3) showing the subsequent process of the method for manufacturing a thin-film solar cell.
FIG. 13 is an explanatory view (4) showing the subsequent process of the method for manufacturing a thin-film solar cell.
FIG. 14 is an explanatory view (5) showing the subsequent process of the method for manufacturing a thin-film solar cell.
FIG 15A is an explanatory view showing the operation of the push-pull mechanism of the present embodiment.
FIG 15B is an explanatory view showing the operation of the push-pull mechanism of the present embodiment.
FIG. 16 is an explanatory view (6) showing the subsequent process of the method for manufacturing a thin-film solar cell using the above apparatus for manufacturing a thin-film solar cell.
FIG. 17 is an explanatory view (7) showing the subsequent process of the method for manufacturing a thin-film solar cell.
FIG. 18 is an explanatory view (8) showing the subsequent process of the method for manufacturing a thin-film solar cell, and is a schematic sectional view when a substrate is inserted into the electrode unit.
FIG. 19 is an explanatory view (9) showing the subsequent process of the method for manufacturing a thin-film solar cell.
FIG. 20 is an explanatory view (10) showing the subsequent process of the method for manufacturing a thin-film solar cell.
FIG. 21 is an explanatory view (11) showing the subsequent process of the method for manufacturing a thin-film solar cell, and is a partial sectional view when a substrate is set on the electrode unit.
FIG. 22 is an explanatory view (12) showing the subsequent process of the method for manufacturing a thin-film solar cell.
FIG. 23 is an explanatory view (13) showing the subsequent process of the method for manufacturing a thin-film solar cell.
FIG. 24 is an explanatory view (14) showing the subsequent process of the method for manufacturing a thin-film solar cell.
FIG. 25 is an explanatory view (15) showing the subsequent process of the method for manufacturing a thin-film solar cell.

### Best Mode for Carrying out the Invention

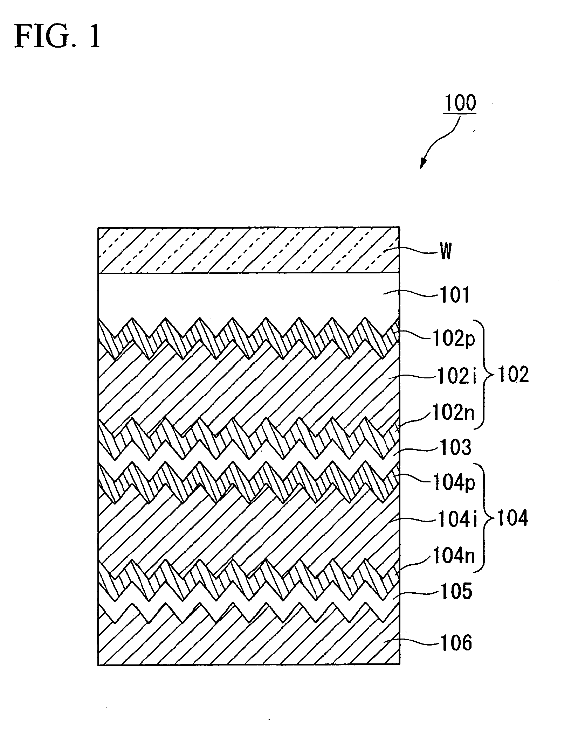

An apparatus for manufacturing a thin-film solar cell related to one embodiment of the present invention will be described with reference to FIGS. 1 to 25.

### (Thin-film Solar Cell)

FIG. 1 is a sectional view schematically showing an example of a thin-film solar cell 100 manufactured by an apparatus for manufacturing a thin-film solar cell of the present invention. As shown in FIG 1, the thin-film solar cell 100 is configured such that a substrate W (for example, a glass substrate or the like) which constitutes the surface of the solar cell; a top electrode 101 made of a transparent conductive film provided on the substrate W; a top cell 102 made of amorphous silicon; an intermediate electrode 103 made of a transparent conductive film provided between the top cell 102 and a bottom cell 104 which will be described later; the bottom cell 104 made of microcrystalline silicon; a buffer layer 105 made of a transparent conductive film; and a back electrode 106 made of a metal film; are laminated. That is, the thin-film solar cell 100 is an amorphous silicon/microcrystalline silicon tandem-type solar cell. In the thin-film solar cell 100 of such tandem structure, power generation efficiency can be improved by absorbing short-wavelength light with the top cell 102 and absorbing long-wavelength light with the bottom cell 104.

The top cell 102 forms a three-layer structure of a p-layer (102p), i-layer (102i), and n-layer (102n), each of which is formed from amorphous silicon. The bottom cell 104 forms a three-layer structure of a p-layer (104p), i-layer (104i), and n-layer (104n), each of which is formed from microcrystalline silicon.

In the thin-film solar cell 100 having such a configuration, when an energy particle called a photon in sunlight strikes the i-layer, an electron and a positive hole (hole) are generated by a photovoltaic effect, the electron moves toward the n-layer and the positive hole moves toward the p-layer. Light energy can be converted into electrical energy by taking out the electron and positive hole generated by the photovoltaic effect from the top electrode 101 and the back electrode 106.

The intermediate electrode 103 is provided between the top cell 102 and the bottom cell 104, whereby a part of the light which passes through the top cell 102 and reaches the bottom cell 104 is reflected by the intermediate electrode 103 and enters the top cell 102 again. Therefore, the sensitivity characteristics of the cell improve, and the power generation efficiency improves.

Additionally, the sunlight which has entered from the substrate W side passes through the respective layers, and is then reflected by the back electrode 106. In order to improve the conversion efficiency of light energy, the thin-film solar cell 100 of the present embodiment adopts a textured structure aiming at a prismatic effect which extends the optical path of the sunlight which has entered the top electrode 101, and the confinement effect of light.

### (Apparatus for Manufacturing Thin-film Solar Cell)

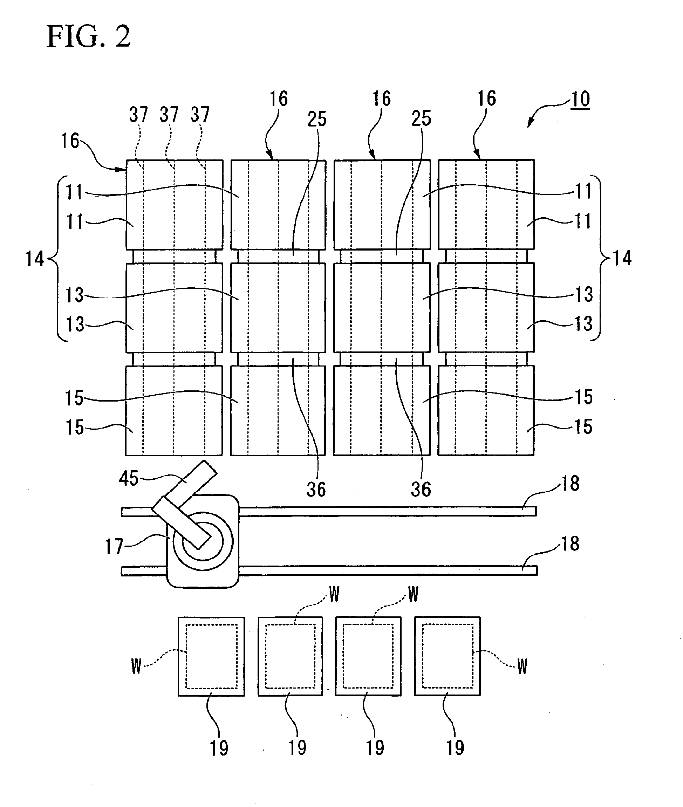

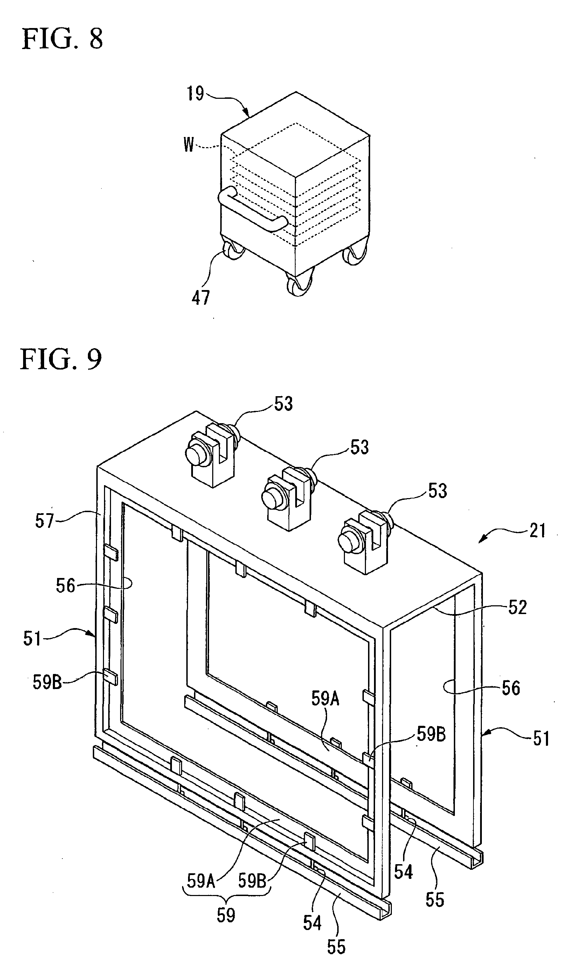

FIG 2 is a schematic plan view of the apparatus for manufacturing a thin-film solar cell related to one embodiment of the present invention. As shown in FIG 2, the apparatus 10 for manufacturing a thin-film solar cell includes: film forming chambers 11 capable of simultaneously film-forming bottom cells 104 (semiconductor layers) made of microcrystalline silicon on a plurality of substrates W; loading-ejecting chambers 13 capable of simultaneously storing pre-processed substrates W1 (substrates W) carried into the film forming chamber 11 and post-processed substrates W2 (substrates W) carried out of the film forming chamber 11; a substrate replacement chamber 15 where the pre-processed substrates W1 and the post-processed substrates W2 are attached to and detached from a carrier 21 (conveying part: refer to FIG 9); a substrate replacement robot 17 for attaching the substrate W to and detaching the substrates W from the carrier 21; and substrate storage holders 19 which store the substrates W in order to convey the substrates to separate processing chambers. In the present embodiment, four substrate film formation lines 16 each including the film forming chamber 11, the loading-ejecting chamber 13, and the substrate replacement chamber 15 are provided. The substrate replacement robot 17 is adapted to be able to move on rails 18 laid on a floor surface. Thereby, transfer of the substrates W to all the substrate film formation lines 16 can be performed by one substrate replacement robot 17. Moreover, the film forming chamber 11 and the loading-ejecting chamber 13 are integrated together to constitute a substrate film formation module 14, and have sizes such that the module can be loaded into an autotruck.

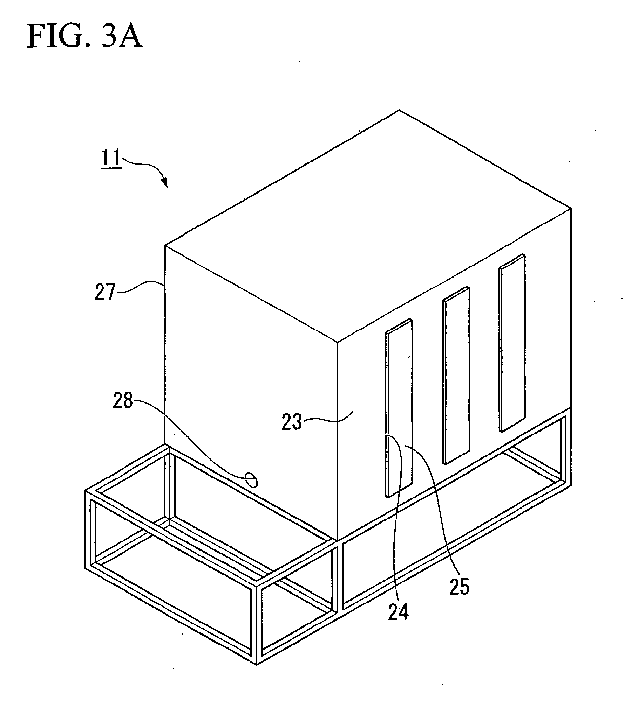

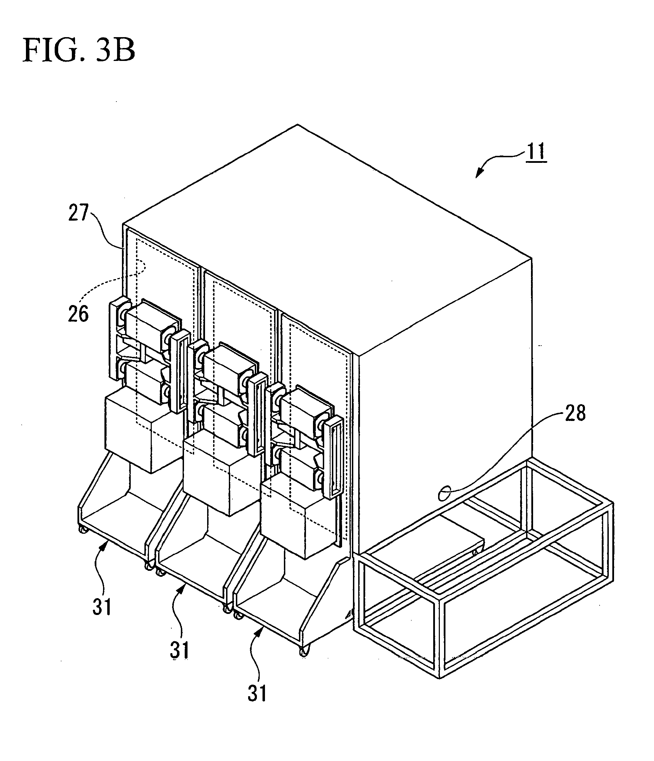

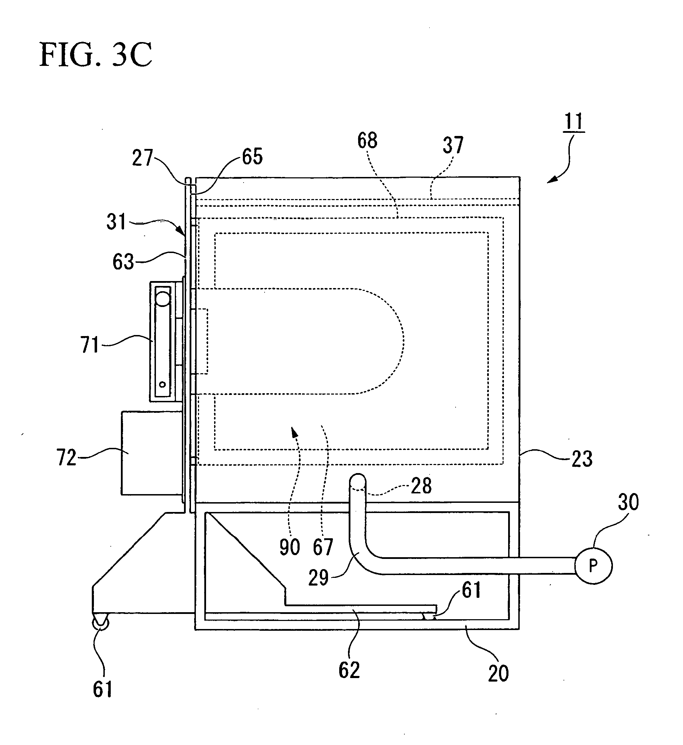

FIGS. 3A to 3C are schematic configuration views of the film forming chamber. FIG 3A is a perspective view, FIG 3B is a perspective view as seen from an angle different from FIG 3A, and FIG 3C is a side view.
As shown in these FIGS. 3A to 3C, the film forming chamber 11 is formed in the shape of a box. A first lateral surface 23 of the film forming chamber 11 connected to the loading-ejecting chamber 13 is formed with three carrier transfer inlet ports 24 which allow the carrier 21 on which the substrates W are mounted to pass therethrough. The carrier transfer inlet ports 24 are respectively provided with shutters 25 which open and close the carrier transfer inlet ports 24. When a shutter 25 is closed, the carrier transfer inlet port 24 is sealed airtight. Three electrode units 31 for forming films on the substrates W are attached to a second lateral surface 27 opposite to the first lateral surface 23. The electrode units 31 are attachable to and detachable from the film forming chamber 11. A vacuum pump 30 for evacuating the space within the film forming chamber 11 is connected to a third lateral surface lower portion 28 of the film forming chamber 11 via a vacuuming pipe 29 (refer to FIG 3C; the illustration is omitted in FIGS. 3A and 3B).

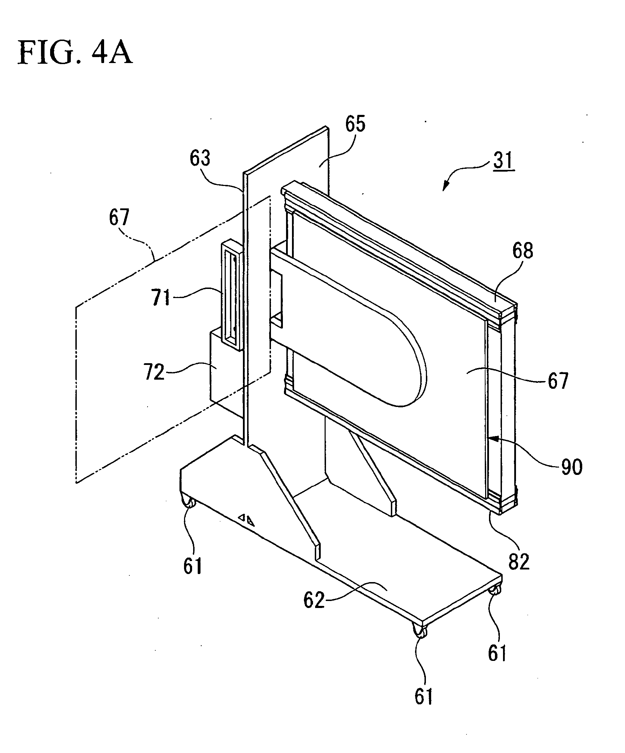

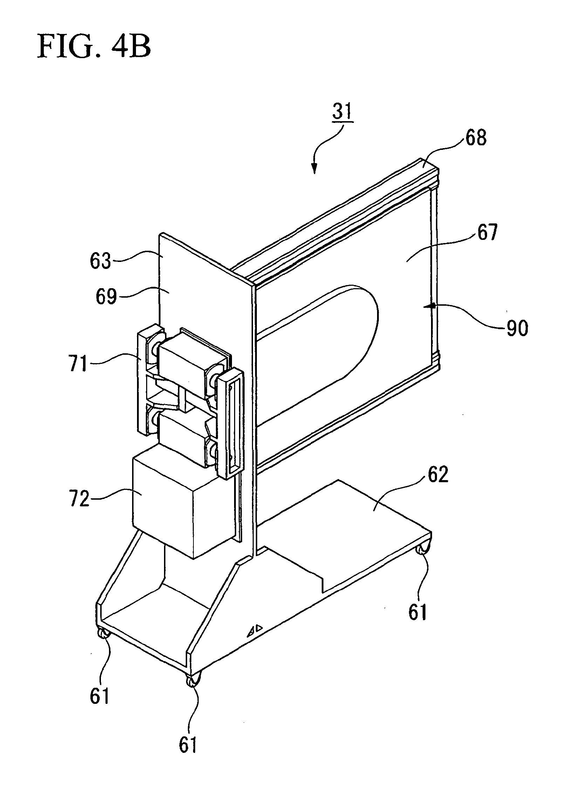

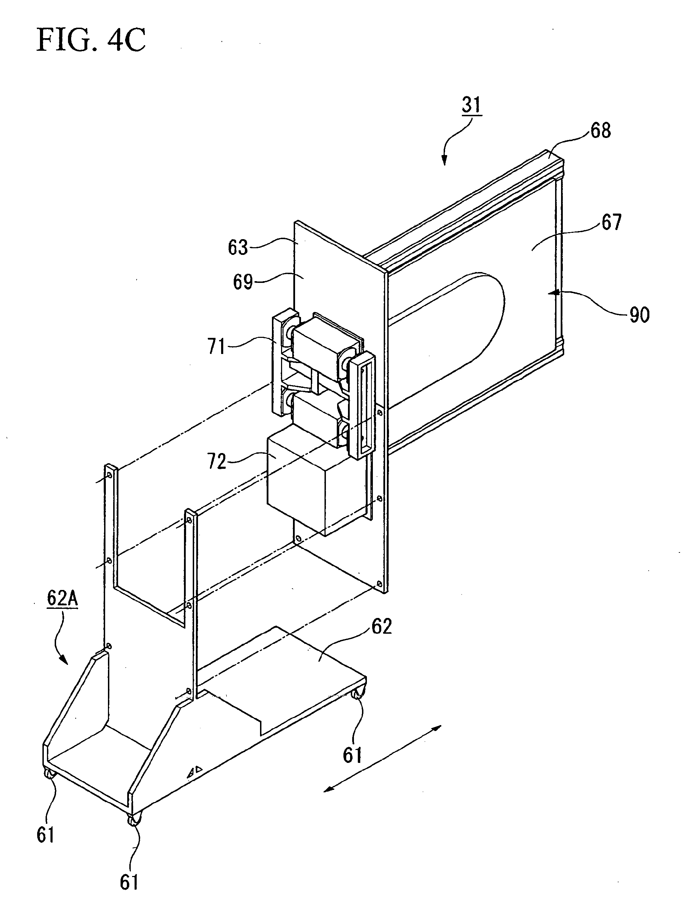

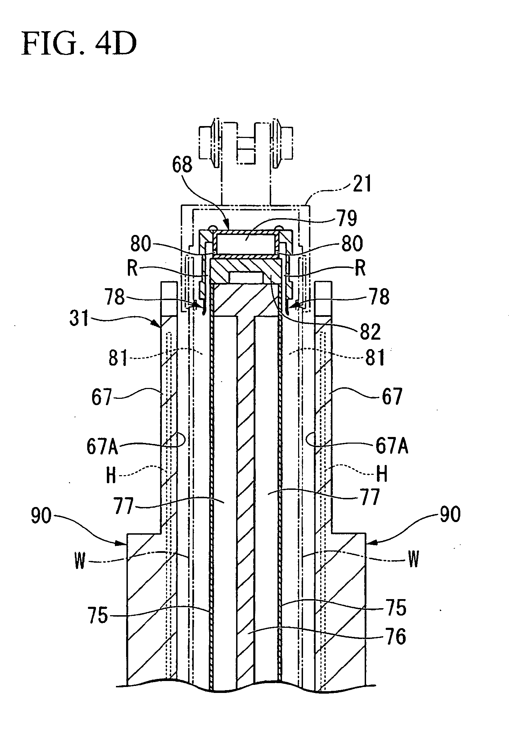

FIGS. 4A to 4D are schematic configuration views of the electrode unit 31. FIG 4A is a perspective view, FIG 4B is a perspective view as seen from an angle different from FIG 4A. FIG 4C is a perspective view showing a modification of the electrode unit 31. FIG 4D is a partial sectional view of a cathode unit and anodes (counter electrodes).
The electrode units 31 are attachable to and detachable from three openings 26 formed in the second lateral surface 27 of the film forming chamber 11 (refer to FIG. 3B). Wheels 61 are provided at each of the four corners of the lower portion (bottom plate portion 62), and the electrode units 31 are movable on the floor surface. On a bottom plate portion 62 to which the wheels 61 are attached, a side plate portion 63 is erected along the vertical direction. The side plate portion 63 has a size such that the side plate portion 63 can block the opening 26 of the second lateral surface 27 of the film forming chamber 11.
As shown in the modification of FIG 4C, the bottom plate portion 62 with the wheels 61 may be a truck 62A which can be separated from and connected to the side plate portion 63 to which the cathode unit 68, the anode unit 90, and the like are attached. In this case, the truck 62A can be separated from the side plate portion 63 to which the cathode unit 68, the anode unit 90, and the like are attached after the electrode unit 31 is connected to the film forming chamber 11, and can be used for the transfer of other electrode units 31 as a common truck 62A.

The side plate portion 63 of the electrode unit 31 forms a part of a wall surface of the film forming chamber 11. One surface (surface which faces the inside of the film forming chamber 11) 65 of the side plate portion 63 is provided with anodes 67 and a cathode unit 68 which are arranged on both surfaces of the substrate W during film formation processing. The electrode unit 31 of the present embodiment includes a pair of anodes 67 arranged so as to be separated from each other with the cathode unit 68 therebetween. Films can be simultaneously formed on two substrates W by one electrode unit 31. Respective substrates W during film formation processing are arranged on both sides of the cathode unit 68, respectively, so as to face each other substantially parallel to the vertical direction. Two anodes 67 are arranged outside respective substrates W in its thickness direction in a state where the anodes face the substrates W, respectively.

Additionally, a drive mechanism (drive part) 71 for driving the anodes 67, and a matching box 72 for feeding electric power to the cathode unit 68 when a film is formed are attached to the other surface 69 of the side plate portion 63. Moreover, the side plate portion 63 is formed with a connecting portion for piping (not shown) which supplies film forming gas to the cathode unit 68.

Heaters H are built in two (a pair of) anodes 67 as temperature control sections for adjusting the temperature of the substrate W. The two anodes 67 and the heaters H constitute the anode unit 90. Additionally, the two anodes 67 and 67 are movable in directions (horizontal directions) in which the anodes approach and separate from each other by the drive mechanism 71 provided at the side plate portion 63, and the separation distance between each substrate W and the cathode unit 68 is controllable. Specifically, before films are formed on the substrates W, the two anodes 67 and 67 move toward the cathode unit 68, and come into contact with the substrates W. Moreover, the two anodes 67 and 67 move in the directions in which the anodes 67 approach the cathode unit 68, and the separation distance between each substrate W and the cathode unit 68 is adjusted to a desired distance. Thereafter, films are formed, and after the end of film forming, the anodes 67 and 67 move in the directions in which the anodes 67 separate from each other, and the anodes 67 and the substrates W separate from each other, so that the substrates W can be easily taken out of the electrode unit 31.
Moreover, each anode 67 is attached to the drive mechanism 71 via a hinge (not shown). Thereby, the anode can be turned so as to be opened and closed until the surface 67A of the anode 67 which faces the cathode unit 68 becomes substantially parallel to one surface 65 of the side plate portion 63, in a state which the electrode unit 31 is pulled out of the film forming chamber 11. That is, the anodes 67 are able to be turned by about 90° in plan view (refer to FIG 4A).

The cathode unit 68 has a shower plate (cathode) 75, a cathode intermediate member 76, a discharge duct 79, and a floating capacitance member 82.
A pair of shower plates 75 formed with a plurality of small holes (not shown) is arranged on the surfaces of the cathode unit 68 which face the anodes 67, respectively so that the film forming gas can be jetted toward the substrates W from the small holes. The shower plates 75 and 75 form cathodes (high-frequency electrode) electrically connected to the matching box 72. The cathode intermediate member 76 electrically connected to the matching box 72 is provided between the two shower plates 75 and 75. That is, the shower plates 75 are arranged on both sides of the cathode intermediate member 76 in a state where the shower plates 75 are electrically connected to the cathode intermediate member 76.

The cathode intermediate member 76 and each shower plate (cathode) 75 are formed from electrical conductors. High frequency waves are applied to the shower plate (cathode) 75 via the cathode intermediate member 76. For this reason, voltages to be applied to the two shower plates 75 and 75 for generating plasma have the same potential and phase.
The cathode intermediate member 76 is electrically connected to the matching box 72 by a wiring which is not shown. A space portion 77 is formed between the cathode intermediate member 76 and each shower plate 75. The film forming gas is introduced into the space portion 77 from a gas supply device (not shown). A pair of space portions 77 is separated from each other by the cathode intermediate member 76 interposed therebetween, and is individually formed so as to correspond to the shower plates 75 and 75, respectively. Therefore, the kinds or discharge amounts of the gases discharged from the respective shower plates 75 and 75 can be independently controlled. That is, the space portion 77 has a role as a gas supply passage. In the present embodiment, the respective space portions 77 are separately formed so as to correspond to the shower plates 75 and 75, respectively. Thus, the cathode unit 68 has two gas supply passages.

A hollow discharge duct 79 is provided at a peripheral edge portion of the cathode unit 68 over the whole periphery thereof. The discharge duct 79 is formed with a vacuuming port 80 for introducing the film forming gas or reactive by-products (powder) within a film formation space 81 into the discharge duct 79, and evacuating the film forming gas or reactive by-products. Specifically, the vacuuming port 80 is formed so as to face the film formation space 81 formed between the substrate W and the shower plate 75 when a film is formed. A plurality of vacuuming ports 80 are formed along the peripheral edge portion of the cathode unit 68, and are configured so that evacuation can be made substantially equal over the whole periphery thereof.
The surface of the discharge duct 79 disposed at the lower portion of the cathode unit 68, which faces the film forming chamber 11, is formed with an opening α (not shown). The film forming gas discharged from the film formation space 81 is discharged into the film forming chamber 11 through the opening α. The gas discharged into the film forming chamber 11 is evacuated to the outside through the vacuuming pipe 29 provided at the lateral lower portion 28 of the film forming chamber 11 (refer to FIG 3C).
The floating capacitance member 82 which has a dielectric body and/or a laminating space for the dielectric body is provided between the discharge duct 79 and the cathode intermediate member 76.
The discharge duct 79 is connected to the ground potential. The discharge duct 79 also functions as a shield frame for preventing abnormal electrical discharge from the cathode 75 and the cathode intermediate member 76.

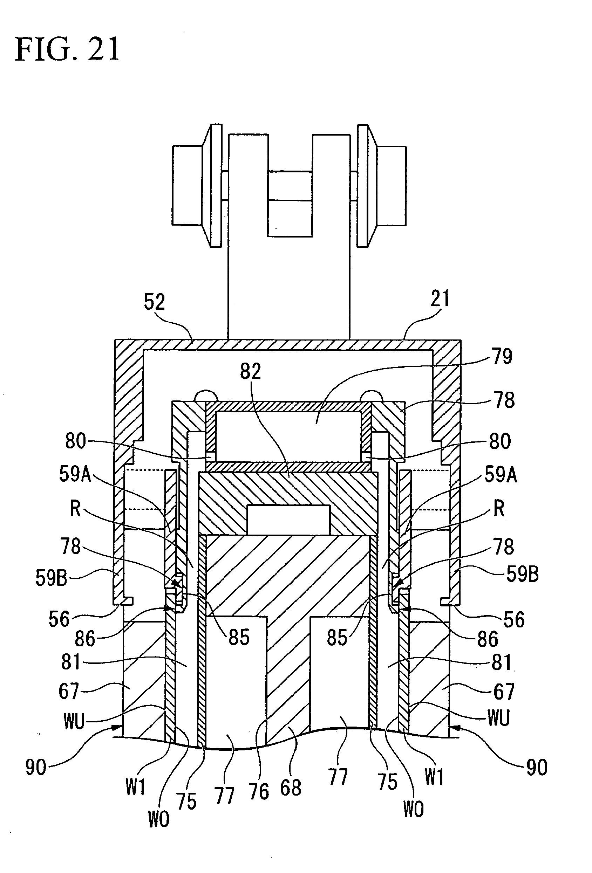

Moreover, a pair of masks 78 is provided at the peripheral edge portion of the cathode unit 68 so as to cover the part from the peripheral portion of the discharge duct 79 to the peripheral portion of the shower plate (cathode) 75. Each of the masks 78 covers a holding piece 59A (refer to FIGS. 9 and 21) of a holding portion 59 (which will be described later) provided at the carrier 21f, and forms a gas flow passage (evacuation passage) R for guiding the film forming gas or reactive by-products (powder) within the film formation space 81 to the discharge duct 79, integrally with the holding piece 59A when a film is formed. That is, the gas flow passage R is formed between the mask 78 which covers the carrier 21 (holding piece 59A) and the shower plate 75, and between the mask 78 and the floating capacitance member 82.

A plurality of transfer rails 37 is laid between the film forming chamber 11 and the substrate replacement chamber 15 so that the carrier 21 can be transferred between the film forming chamber 11 and the loading-ejecting chamber 13, and between the loading-ejecting chamber 13 and the substrate replacement chamber 15 (refer to FIG 2). The transfer rails 37 are separated between the film forming chamber 11 and the loading-ejecting chamber 13, and the carrier transfer inlet ports 24 are sealed by closing the shutters 25.

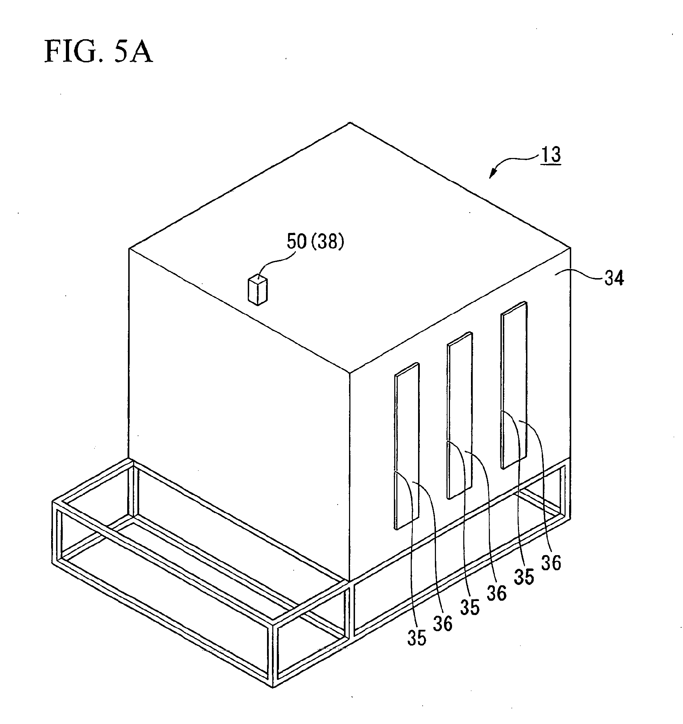

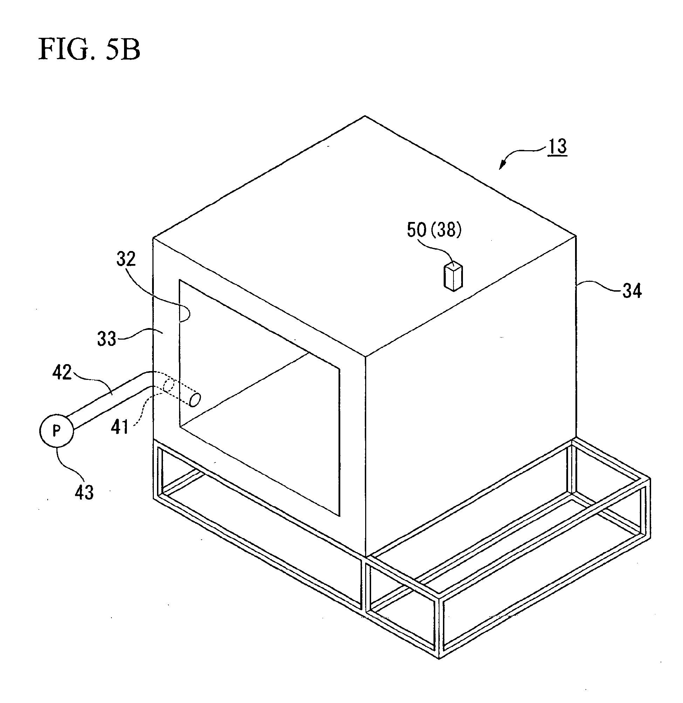

FIGS. 5A and 5B are schematic perspective views of the loading-ejecting chamber 13. FIG. 5A is a perspective view, and FIG. 5B is a perspective view as seen from an angle different from FIG. 5A. As shown in FIGS. 5A and 5B, the loading-ejecting chamber 13 is formed in the shape of a box. A first lateral surface 33 is connected to the first lateral surface 23 of the film forming chamber 11 while securing airtightness. The first lateral surface 33 is formed with an opening 32 through which three carriers 21 can be inserted. A second lateral surface 34 which is opposite to the first lateral surface 33 is connected to the substrate replacement chamber 15. The second lateral surface 34 is formed with three carrier transfer inlet ports 35 which allow the carrier 21 on which the substrates W are mounted to pass therethrough. Each carrier transfer inlet port 35 is provided with a shutter 36 which can secure airtightness. The respective transfer rails 37 are separated between the loading-ejecting chamber 13 and the substrate replacement chamber 15, and the carrier transfer inlet ports 35 are sealed by closing the shutters 36.

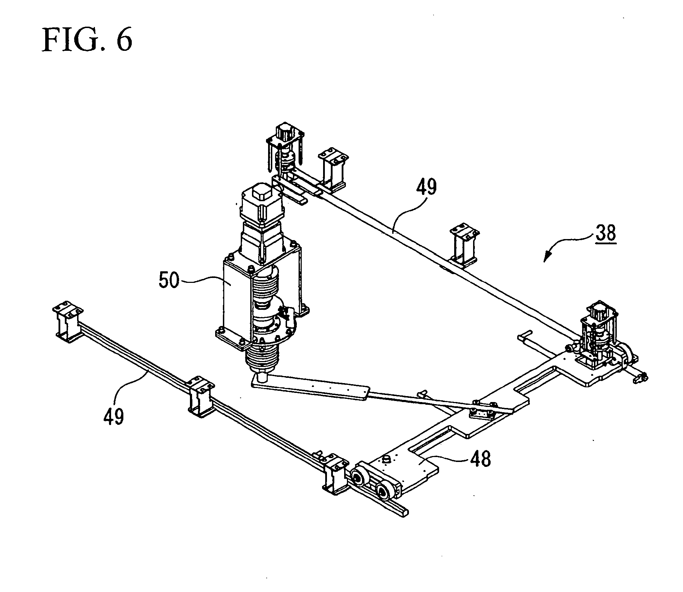

The loading-ejecting chamber 13 is provided with a push-pull mechanism 38 for transferring the carrier 21 between the film forming chamber 11 and the loading-ejecting chamber 13 along the transfer rails 37. As shown in FIG 6, the push-pull mechanism 38 includes: a locking portion 48 for locking the carrier 21; a pair of guide members 49 provided at both ends of the locking portion 48, and disposed substantially parallel to the transfer rails 37; and a transfer device 50 for moving the locking portion 48 along both the guide members 49.

Moreover, a transfer mechanism (not shown) for simultaneously storing the pre-processed substrate W1 and the post-processed substrate W2 is provided within the loading-ejecting chamber 13. The transfer mechanism transfers the carrier 21 by a predetermined distance in a direction substantially orthogonal to the direction in which the transfer rails 37 are laid in plan view.
A vacuum pump 43 for evacuating the inside of the loading-ejecting chamber 13 is connected to a third lateral surface lower portion 41 of the loading-ejecting chamber 13 via a vacuuming pipe 42 (refer to FIG 5B).

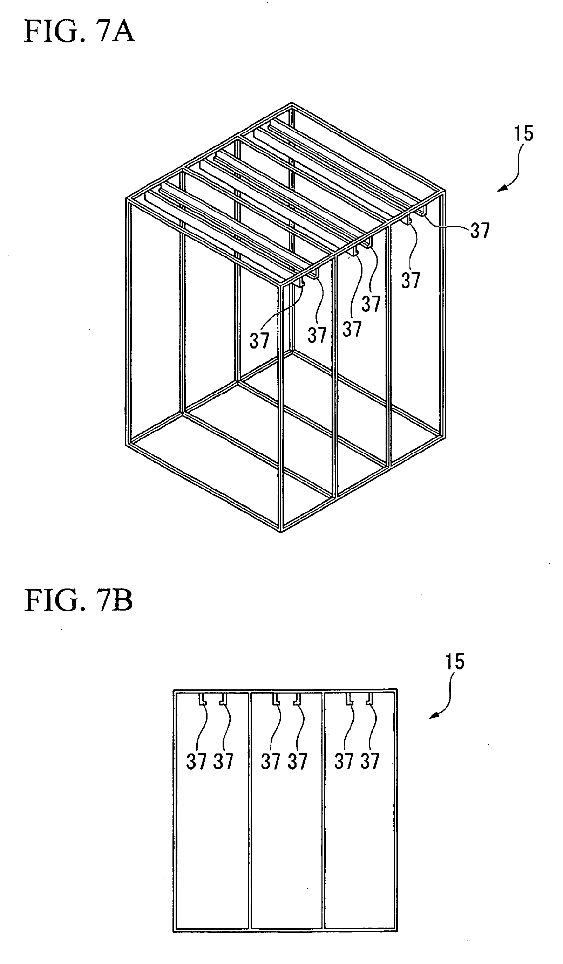

FIGS. 7A and 7B are schematic configuration views of the substrate replacement chamber. FIG 7A is a perspective view, and FIG 7B is a front view. As shown in FIGS. 7A and 7B, the substrate replacement chamber 15 is made of a frame-like body, and is connected to the second lateral surface 34 of the loading-ejecting chamber 13. In the substrate replacement chamber 15, attachment of the pre-processed substrates W1 and removal of the post-processed substrates W2 are performed with respect to the carrier 21 disposed at the transfer rails 37. Three carriers 21 can be arranged in parallel at the substrate replacement chamber 15.

As shown in FIG. 2, the substrate replacement robot 17 has a drive arm 45. The drive arm 45 is adapted to be able to suction a substrate W with its tip. Additionally, the drive arm 45 moves between the carrier 21 disposed at the substrate replacement chamber 15, and the substrate storage holder 19 so that the pre-processed substrate W1 can be taken out of the substrate storage holder 19, and the pre-processed substrate W1 can be attached to the carrier 21 disposed at the substrate replacement chamber 15. Additionally, the drive arm 45 can remove the pre-processed substrate W2 from the carrier 21 which has returned to the substrate replacement chamber 15, and can also convey the substrate W2 to the substrate storage holder 19.

FIG. 8 is a perspective view of the substrate storage holder 19. As shown in FIG. 8, the substrate storage holder 19 is formed in the shape of a box, and has a size such that the holder can store a plurality of substrates W. A plurality of substrates W can be stacked and stored in the up-and-down direction within the substrate storage holder 19 in a state where the film-formation faces of the substrates are made horizontal. Additionally, casters 47 are provided at four corners of a lower portion of the substrate storage holder 19 so as to allow for easy movement to separate processing apparatuses.

FIG. 9 is a perspective view of a carrier which conveys substrates W. As shown in FIG. 9, the carrier 21 includes two frame-like frames 51 to which the substrates W can be attached. That is, two substrates W can be attached to one carrier 21. Two frames 51 and 51 are connected together by a connection member 52 at the upper portions thereof. A plurality of wheels 53 to be placed on the transfer rails 37 are provided on the top surface of the connection member 52. When the wheels 53 roll on the transfer rails 37, the carrier 21 is movable along the transfer rails 37. A lower portion of each frame 51 is provided with a frame holder 54 for suppressing the shaking of the substrate W when the carrier 21 is transferred. A lower end of the frame holder 54 is fitted into a rail member 55 with a concave cross-section provided on the bottom surface of each chamber. The rail members 55 are disposed along the transfer rails 37 in plan view. More stable conveyance becomes possible if the frame holder 54 is constituted of a plurality of rollers.

Each frame 51 has a peripheral edge portion 57 and a holding portion 59. The film formation face of the substrate W is exposed to an opening 56 formed in the frame 51. In the peripheral edge portion 57 of the opening 56, the holding portion 59 is adapted to hold and fix the substrate W from both sides thereof. A biasing force acts on the holding portion 59 which holds the substrate W by a spring or the like. Additionally, as shown in FIG. 21, the holding portion 59 has holding pieces 59A and 59B which abut the front surface WO (film formation face) and rear surface WU (back surface) of the substrate W. The separation distance between the holding piece 59A and the holding pieces 59B is variable via the spring or the like. That is, the separation distance is variable along the directions in which the holding piece 59A approaches and separates from the holding piece 59B according to the movement of the anode 67 (the details thereof will be described later). Here, one carrier 21 (one carrier 21 which can hold a pair of (two) substrates W) is attached onto one transfer rail 37. That is, three carriers (3 pairs of (six) substrates are held) 21 are attached to one substrate film formation line 16 constituted by a film forming chamber 11, a loading-ejecting chamber 13, and a substrate replacement chamber 15.

In the apparatus 10 for manufacturing a thin-film solar cell of the present embodiment, the above-described four substrate film formation lines 16 are arranged, and three carriers 21 are stored in one film forming chamber 11. Therefore, films can be substantially simultaneously formed on twenty four substrates W.

### (Method for Manufacturing Thin-film Solar Cell)

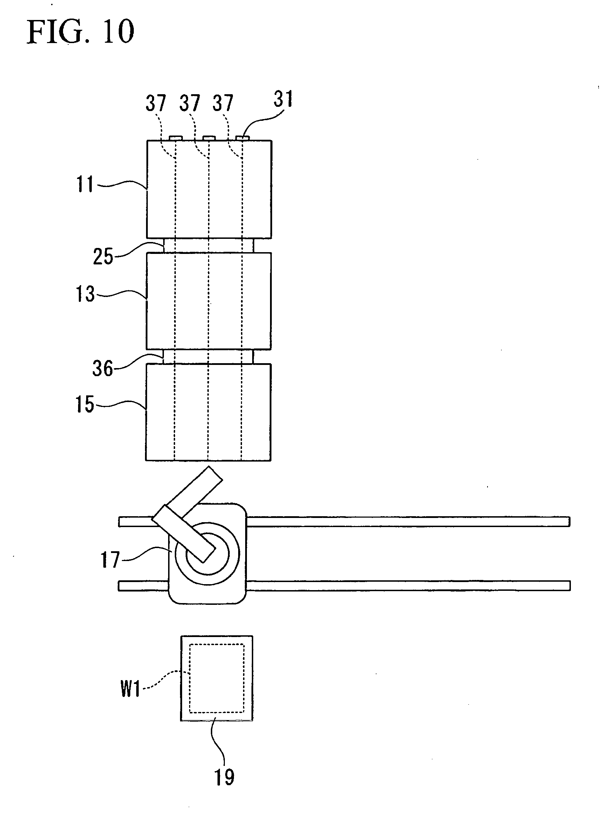

Next, a method for forming a film on a substrate W using the apparatus 10 for manufacturing a thin-film solar cell of the present embodiment will be described. Although one substrate film formation line 16 is depicted in this description, the other three substrate film formation lines 16 form films on substrates W according to almost the same flow.
First, as shown in FIG. 10, the substrate storage holder 19 which stores a plurality of pre-processed substrates W1 is arranged at a predetermined position.

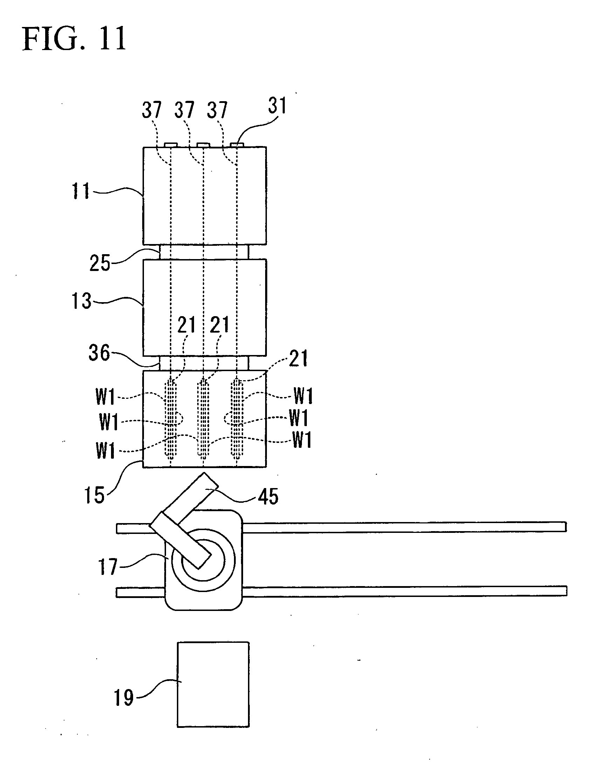

Subsequently, as shown in FIG. 11, the drive arm 45 of the substrate replacement robot 17 is operated to take one pre-processed substrate W1 out of the substrate storage holder 19, and attaches the substrate W1 to a carrier 21 within the substrate replacement chamber 15. At this time, the pre-processed substrate W1 which has been arranged in the horizontal direction in the substrate storage holder 19 is attached to the carrier 21 after its orientation is changed to the vertical direction. This operation is repeated once again to attach two pre-processed substrates W1 to one carrier 21.
Moreover, this operation is repeated to attach the pre-processed substrates W1 even to the remaining two carriers 21 within the substrate replacement chamber 15, respectively. That is, six pre-processed substrates W1 are attached in this process.

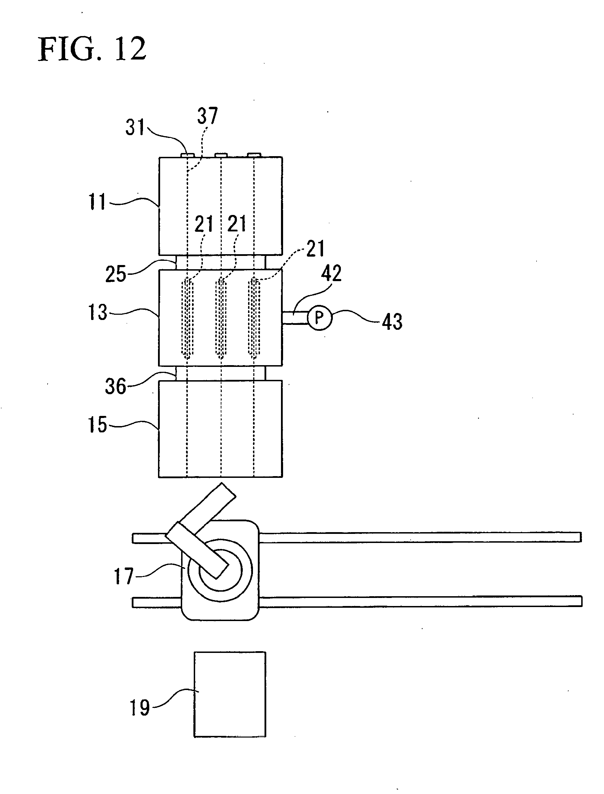

Subsequently, as shown in FIG. 12, the three carriers 21 to which the pre-processed substrates W1 are attached are substantially simultaneously transferred along the respective transfer rails 37, and are stored within the loading-ejecting chamber 13. After the carriers 21 are stored within the loading-ejecting chamber 13, the shutters 36 of the carrier transfer inlet ports 35 of the loading-ejecting chamber 13 are closed. Thereafter, the inside of the loading-ejecting chamber 13 is held in a vacuum state using the vacuum pump 43.

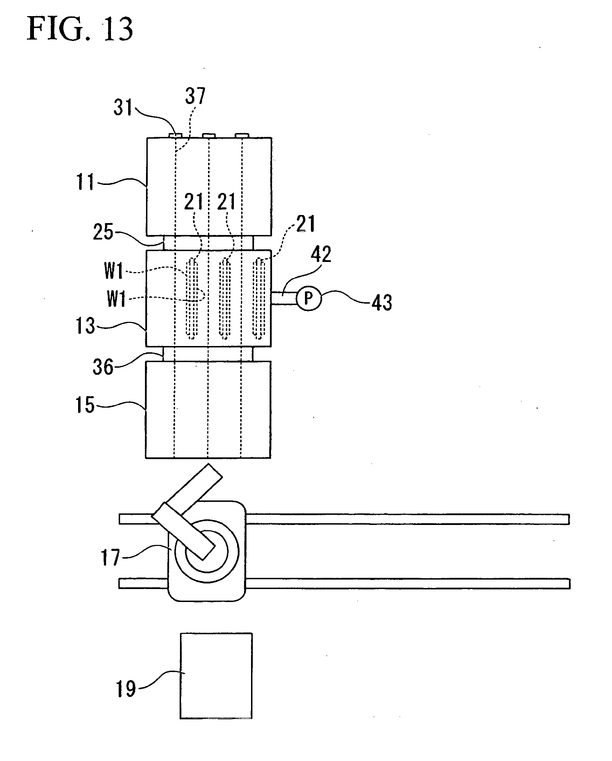

Subsequently, as shown in FIG 13, the three carriers 21 are respectively transferred by a predetermined distance using the transfer mechanism, in a direction orthogonal to the direction in which the respective transfer rails 37 are laid in plan view.

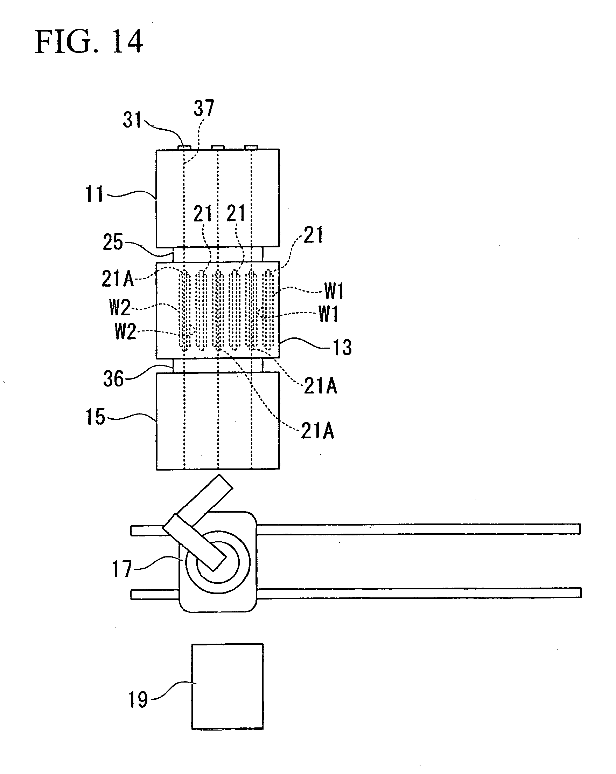

Subsequently, as shown in FIG. 14, the shutters 25 of the film forming chamber 11 are brought into an opened state, and the carriers 21A to which the post-processed substrates W2 of which the film forming has been ended in the film forming chamber 11 are attached are transferred to the loading-ejecting chamber 13, using the push-pull mechanism 38. At this time, the carrier 21 holding the pre-processed substrates W1 and the carrier 21A holding the post-processed substrates W2 are alternately arranged in parallel in plan view. By maintaining this state for a predetermined time, the heat which is accumulated in the post-processed substrates W2 is transferred to the pre-processed substrates W1. That is, the pre-processed substrates W1 are heated.

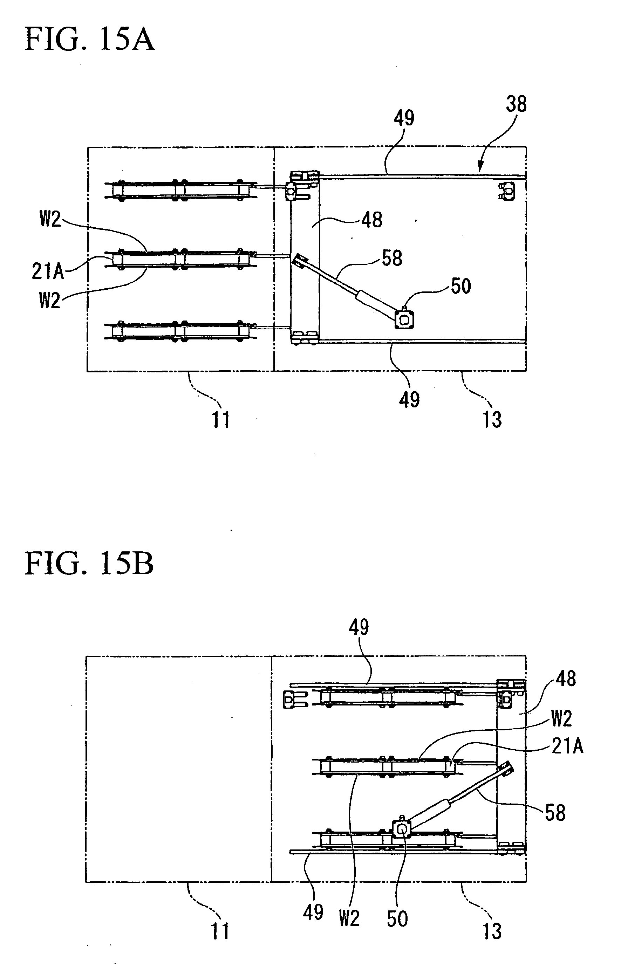

Here, the operation of the push-pull mechanism 38 will be described. Here, the operation when the carriers 21 A within the film forming chamber 11 are transferred into the loading-ejecting chamber 13 will be described.
As shown in FIG. 15A, the carriers 21 A to which the post-processed substrates W2 is attached are locked to the locking portion 48 of the push-pull mechanism 38. Then, the transfer arm 58 of the transfer device 50 attached to the locking portion 48 is swung. At this time, the length of the transfer arm 58 is variable. Then, the locking portion 48 to which the carriers 21A have been locked moves while being guided by the guide members 49, and as shown in FIG 15B, carriers 21A move into the loading-ejecting chamber 13 from the film forming chamber 11. By adopting such a configuration, it becomes unnecessary to provide a drive source for driving the carriers 21A within the film forming chamber 11.

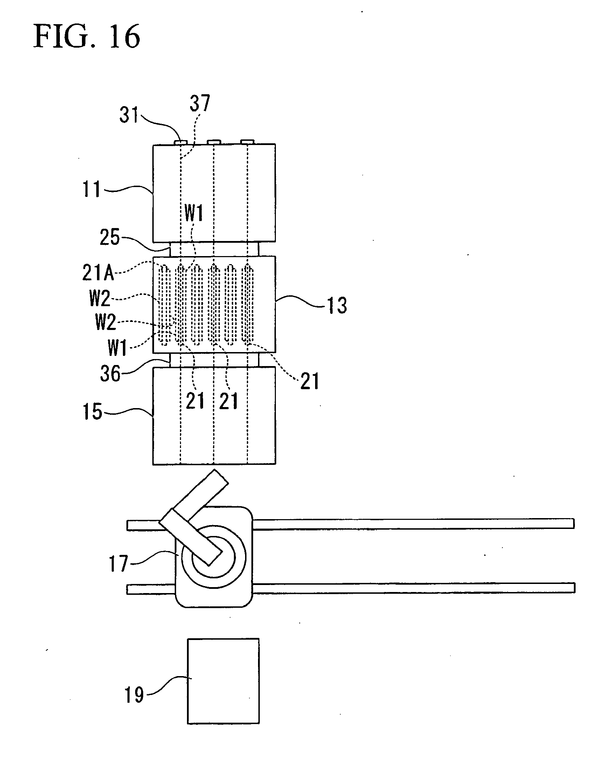

Subsequently, as shown in FIG. 16, the carriers 21 and the carriers 2 1 A are transferred in a direction orthogonal to the transfer rails 37 by the transfer mechanism, and the respective carriers 21 holding the pre-processed substrates W1 are transferred to the positions of their respective transfer rails 37.

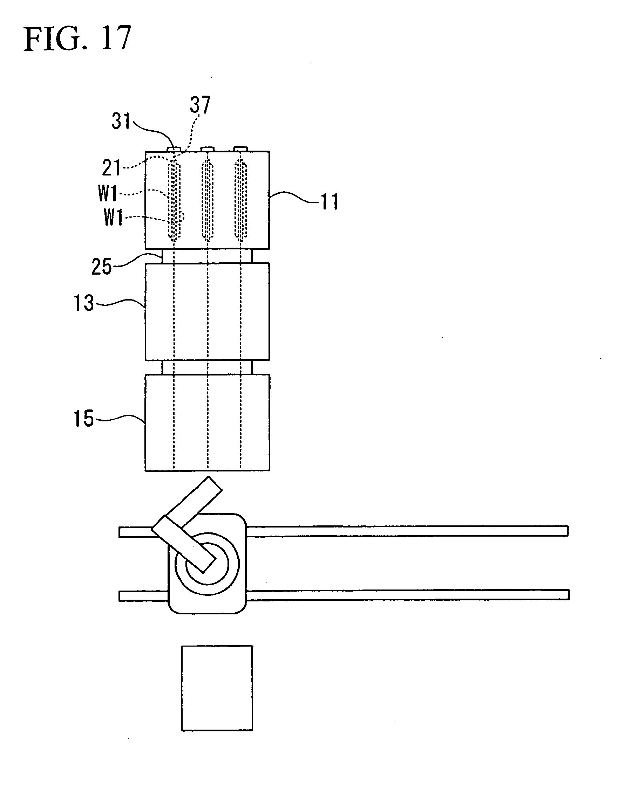

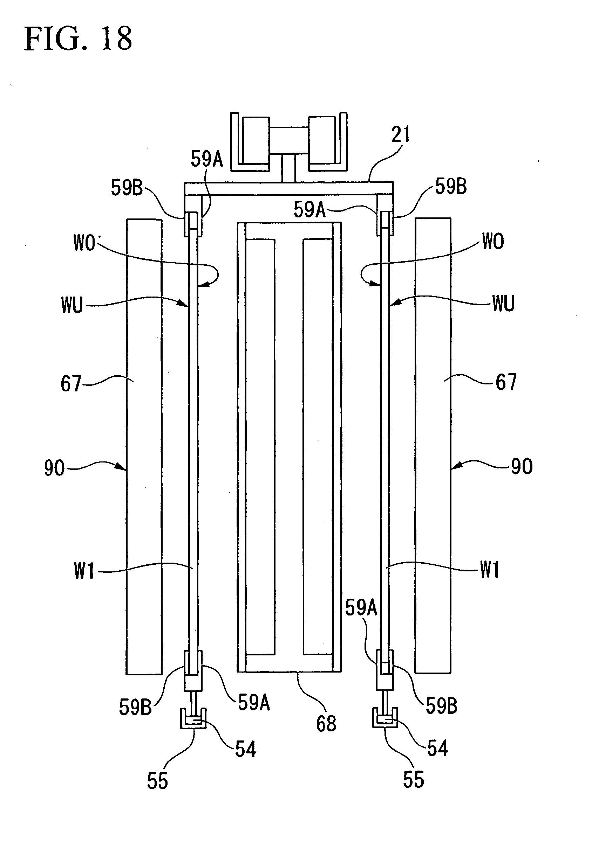

Subsequently, as shown in FIG. 17, the respective carriers 21 holding the pre-processed substrates W1 are transferred into the film forming chamber 11, using the push-pull mechanism 38, and the shutters 25 are closed after the completion of transfer. The vacuum state is maintained within the film forming chamber 11. At this time, the pre-processed substrates W1 attached to each carrier 21 move along the planar direction thereof, and are inserted between the anodes 67 and the cathode unit 68 within the film forming chamber 11 so that the front surfaces WO of the pre-processed substrates W1 become substantially parallel to the vertical direction (refer to FIG. 18).

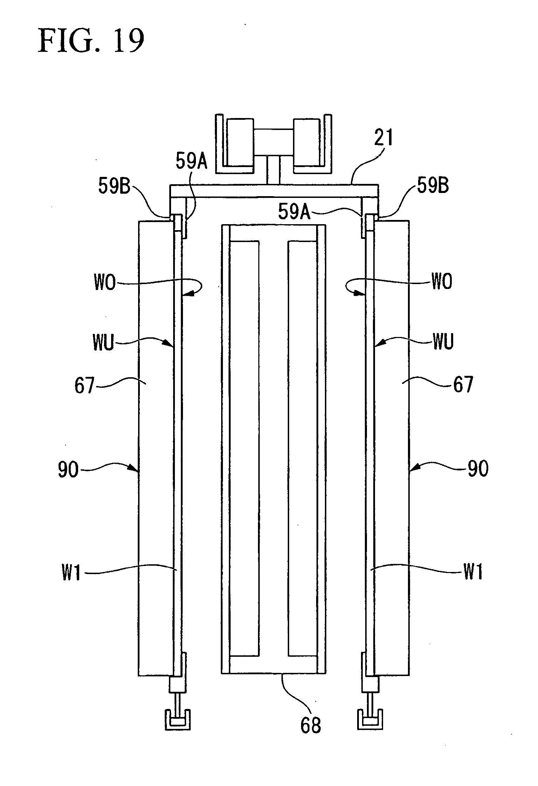

Subsequently, as shown in FIGS. 18 and 19, the anodes 67 are made to come into contact with the rear surfaces WU of the pre-processed substrates W1 by moving the two anodes 67 in directions in which the anodes approach each other using the drive mechanism 71.

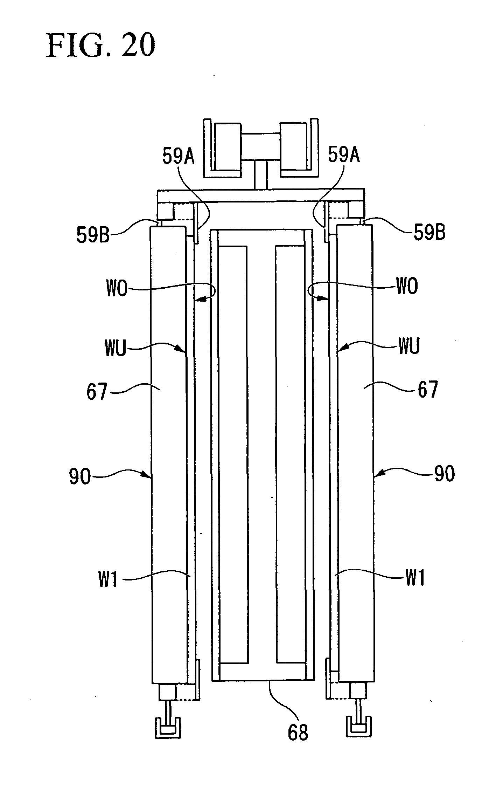

As shown in FIG. 20, when the drive mechanism 71 is further driven, the pre-processed substrates W1 move toward the cathode unit 68 so as to be pushed by the anodes 67. Moreover, the pre-processed substrates W1 are moved until the gap between the pre-processed substrate W1 and the shower plate 75 of the cathode unit 68 reaches a predetermined distance (film forming distance). The gap (film forming distance) between the substrate W1 before this film formation processing and the shower plate 75 of the cathode unit 68 is within a range of 5 to 15 mm, and is preferably set to, for example, about 5 mm.

At this time, the holding piece 59A of the holding portion 59 of the carrier 21 which abuts the front surface WO of the pre-processed substrate W1 is displaced in a direction away from the holding piece 59B with the movement (movement of the anode 67) of the pre-processed substrate W1. At this time, the pre-processed substrate W1 is held between the anode 67 and the holding piece 59A. When the anode 67 has moved toward the direction away from the cathode unit 68, since the restoring force of the spring which is not shown acts on the holding piece 59A, the holding piece 59A is displaced toward the holding piece 59B.

When the pre-processed substrate W1 moves toward the cathode unit 68, the substrate W abuts the mask 78, and the movement of the anode 67 stops at this time (refer to FIG 21).
As shown in FIG 21, the mask 78 is formed so as to cover the outer-edge portion of the substrate W and come into close contact with the outer-edge portion of the substrate W. The film formation space 81 is formed by the mask 78, the shower plate 75 of the cathode unit 68, and the pre-processed substrate W1 (substrate W).
That is, the film formation space 81 and the space in the chamber in which the carrier 21 and the conveying device exist are separated when the masks 78 and the substrate W abut each other. Moreover, a mating surface (abutting surface) between the mask 78 and the substrate W is constituted as a seal portion 86 so that the film forming gas does not leak out from between the mask 78 and the substrate W. This limits the range where the film forming gas spreads, and can keep a film from being formed in an unnecessary range. As a result, since the cleaning range can be narrowed and the cleaning frequency can be reduced, the operating rate of the apparatus 10 for manufacturing a thin-film solar cell improves.

The movement of the pre-processed substrate W1 stops when the outer-edge portion of the substrate abuts the mask 78. Therefore, the gap between the mask 78 and the shower plate 75 and the gap of the mask 78 and the floating capacitance member 82, that is, the flow passage dimension of the gas flow passage R in the thickness direction and the gap between the pre-processed substrate W1 and the cathode unit 68 are set to be predetermined distances.
As another form, the distance between the substrate W and the shower plate (cathode) 75 can also be arbitrarily changed by the stroke of the drive mechanism 71 by attaching the mask 78 to the discharge duct 79 via an elastic body. In the above embodiment, the mask 78 and the substrate W abut each other. However, the mask 78 and the substrate W may be arranged so as to leave a minute gap which limits the passage of the film forming gas.

Subsequently, the film forming gas is jetted from the shower plate 75 of the cathode unit 68, and the matching box 72 is started to apply a voltage to the cathode 76 of the cathode unit 68. This generates plasma in the film formation space 81, thereby forming a film on the front surface WO of the pre-processed substrate W1. At this time, the pre-processed substrate W1 is heated to a desired temperature by the heater H (for example, a heating wire, a constant-temperature liquid passage, or the like) built in the anode 67.

The anode 67 stops heating when the pre-processed substrate W1 reaches a desired temperature. However, when plasma is generated in the film formation space 81 by applying a voltage to the shower plate (cathode) 75, even if the heating of the anode 67 is stopped, there is a possibility that the temperature of the pre-processed substrate W1 may rise higher than the desired temperature due to the heat input from the plasma with the passage of time. In this case, the anode 67 can also be made to function as a radiator plate for cooling the pre-processed substrate W1 when the temperature has risen excessively. Accordingly, the temperature of the pre-processed substrate W1 is adjusted to a desired temperature irrespective of the passage of the film formation processing time.
When a plurality of layers is film-formed through one film formation processing process, this film formation can be carried out by switching the film forming gas material to be supplied every predetermined time.

During film forming and after film forming, the gas or reactive by-products (powder) in the film formation space 81 flows into the discharge duct 79 from the vacuuming ports 80 formed in the peripheral edge portion of the cathode unit 68 via the gas flow passage R. The gas which has flowed into the discharge duct 79 passes through the opening α of the discharge duct 79 arranged at the lower portion of the cathode unit 68, and is evacuated to the outside from the vacuuming pipe 29 provided at the lateral lower portion 28 of the film forming chamber 11. Meanwhile, the reactive by-products (powder) generated when a film is formed can be collected and disposed of when being made to adhere to and deposited on the inner wall surface of the discharge duct 79.
Since the same processing as the above-described processing is performed in all the electrode units 31 within the film forming chamber 11, film formation processing can be simultaneously performed on all six substrates.

When the film formation processing is ended, the two anodes 67 are moved in directions away from each other by the drive mechanism 71, and the post-processed substrates W2 and the frames 51 (holding pieces 59A) are returned to their original positions (refer to FIG19). That is, when the film formation is ended and the carrier 21 is transferred, the masks 78 are removed through the exposure surfaces 85 of the holding pieces 59A.
Moreover, by moving the anodes 67 in opposing directions away from each other, the post-processed substrates W2 and the anodes 67 are separated from each other (refer to FIG 18).

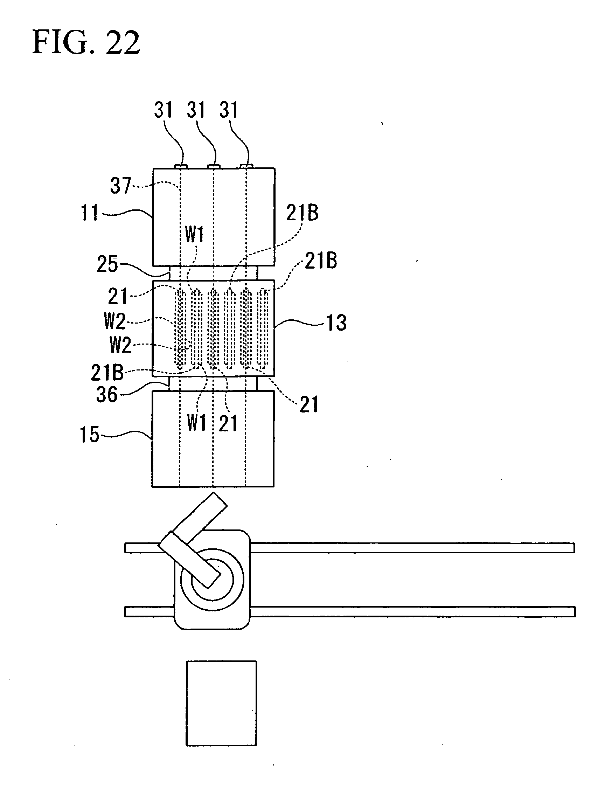

Subsequently, as shown in FIG. 22, the shutters 25 of the film forming chamber 11 are opened, and each carrier 21 is transferred into the loading-ejecting chamber 13, using the push-pull mechanism 38. At this time, the inside of the loading-ejecting chamber 13 is evacuated, and the carriers 21B to which the pre-processed substrates W1 to be film-formed next are already arranged. Then, the heat accumulated in the post-processed substrates W2 is transferred to the pre-processed substrates W1 within the loading-ejecting chamber 13, and the temperature of the post-processed substrates W2 is lowered.

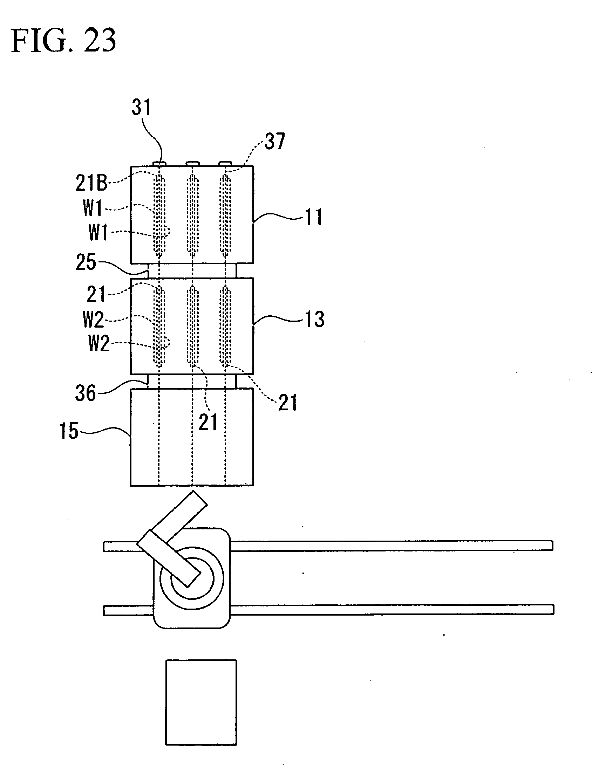

Subsequently, as shown in FIG. 23, after each carrier 21B is transferred into the film forming chamber 11, each carrier 21 is returned to the position of the transfer rails 37 by the transfer mechanism.

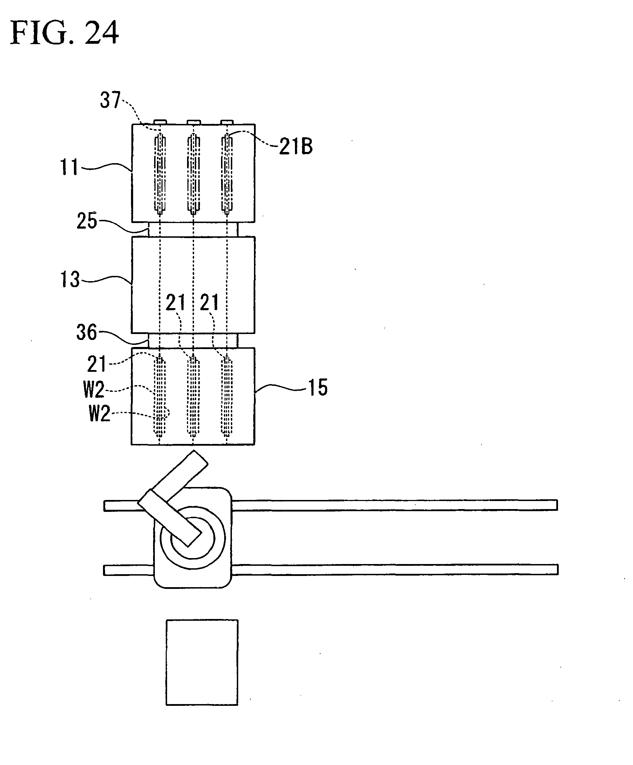

Subsequently, as shown in FIG. 24, after the shutters 25 are closed, the inside of the loading-ejecting chamber 13 is brought to atmospheric pressure, the shutters 36 are opened, and each carrier 21 is transferred into the substrate replacement chamber 15.

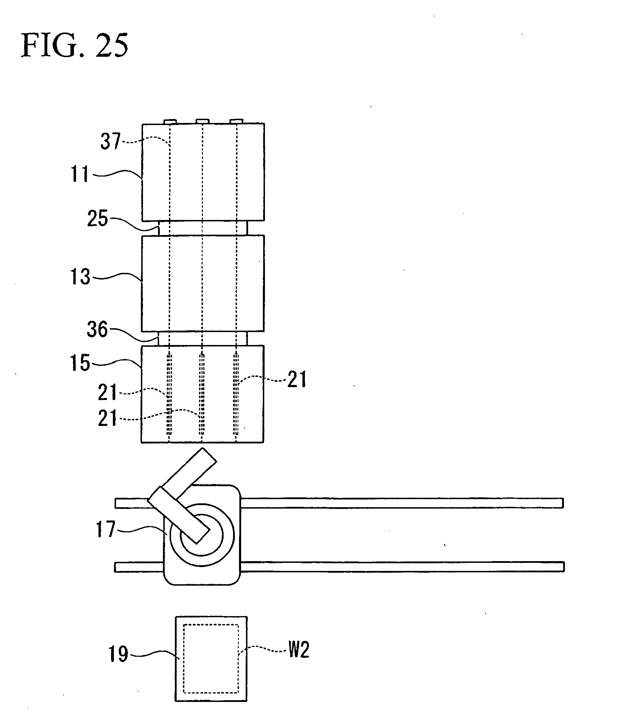

Subsequently, as shown in FIG. 25, each post-processed substrate W2 is removed from each carrier 21 by the substrate replacement robot 17 within the substrate replacement chamber 15, and is transferred to the substrate storage holder 19. When removal of all the post-processed substrates W2 is completed, the film formation processing is ended by moving the substrate storage holder 19 to a place for the following process.

Therefore, according to the above-described embodiment, the substrate W is conveyed using the carrier 21. Thus, the substrate W can be continuously moved between the film forming chamber 11, the loading-ejecting chamber 13, and the substrate replacement chamber 15 for every film forming process, and productivity can be improved.
Additionally, when a film is formed on the front surface WO which is the film formation face of a substrate W, the film formation space 81 is formed by the cathode unit 68, the substrate W, and the mask 78. Therefore, the anode 67 or the carrier 21 can be prevented from being exposed to the film formation space 81.

In addition, when a film is formed on the front surface WO of the substrate W, the outer-edge portion of the substrate W is covered with the mask 78 and when the substrate W is conveyed, the substrate and the mask 78 are separated from each other. As such, it is not necessary to simultaneously move the carrier 21 and the mask 78 during the movement of the substrate W. Thus, the film formed on the mask 78 can be prevented from being peeled off and adhering to the front surface WO of the substrate W. Hence, the quality of a film to be formed on the front surface WO of the substrate W can be improved.

Additionally, the anode 67 is moved by the drive mechanism 71, and the holding piece 59A is separated from the holding piece 59B with the movement of the anode 67, and is made to abut the mask 78. That is, the exposure surface 85 of the holding piece 59A of the carrier 21 is covered with the mask 78, which is brought about by the movement of the anode 67. For this reason, the configuration of the mask 78 provided at the peripheral edge portion of the cathode unit 68 can be simplified.

Moreover, the cathode unit 68 which is comparatively difficult to move is disposed between two substrates W, that is, substantially at the center of the film forming chamber 11. Meanwhile, the anodes 67 which are comparatively easy to move are disposed outside two substrates W, that is, at the lateral surface of the film forming chamber 11. The separation distance between the substrate W and the cathode unit 68 is controlled by making the anode 67 movable by the drive mechanism 71. For this reason, as compared to a case where the cathode unit 68 is moved, complication of the apparatus 10 for manufacturing a thin-film solar cell can be suppressed, and the manufacturing costs of the apparatus 10 for manufacturing a thin-film solar cell can be reduced.

Additionally, the holding portion 59 provided at the carrier 21 has holding pieces 59A which abut the front surface WO of the substrate W, and holding pieces 59B which abut the rear surface WU of the substrate W. The separation distance between the holding pieces 59A and 59B is variable via the spring or the like, that is, the holding piece 59A is configured to be movable along the directions in which the holding piece 59A approach and separates from the holding piece 59B according to the movement of the anode 67. For this reason, with the movement of the anode 67, the substrate W can be easily brought close to or separated from the cathode unit 68.
Moreover, since the mask 78 just has to be formed in a shape such that the mask 78 can cover the holding piece 59A of the carriers 21, the masks 78 can be further miniaturized and simplified.

Since the film formation space 81 is formed by the holding piece 59A covered with the mask 78, the shower plate 75 of the cathode unit 68, and the pre-processed substrate W1 (substrate W), the film formation space 81 can be prevented from being expanded more than needed. As a result, it becomes unnecessary to discharge the film forming gas wastefully, and it is possible to reduce manufacturing costs.

Additionally, a hollow discharge duct 79 is provided at a peripheral edge portion of the cathode unit 68 over the whole periphery thereof. This enables the film forming gas (exhaust gas) to be evacuated from the whole periphery of the substrate W. For this reason, it is possible to improve evacuation efficiency.
Additionally, for example, reactive by-products (powder) or the like generated when a film is formed can be easily collected by performing evacuation using the discharge duct 79. The reactive by-products (powder) can be collected and disposed of when being made to adhere to the inner wall surface of the discharge duct 79. For this reason, it is possible to bring the film forming gas evacuated to the outside from the vacuuming pipe 29 provided at the lateral lower portion 28 of the film forming chamber 11 to a comparatively clean state where reactive by-products (powder) are not included. Moreover, when the discharge duct 79 is cleaned, the reactive by-products (powder) can be cleaned together.

Moreover, the gas flow passage R which leads the film forming gas jetted toward the substrate W to the discharge duct 79 is formed by the mask 78, and the shower plate 75 or the floating capacitance member 82 (refer to FIG 21). The film formation space 81 is formed by the cathode unit 68, the substrate W and the mask 78, and the reactive by-products (powder) and the film forming gas are discharged by the discharge duct 79 via the gas flow passage (evacuation passage) R from the film formation space 81. Therefore, diffusion of the film forming gas or reactive by-products (powder) to other regions can be limited, and contamination in regions other than the film formation space 81 within the film forming chamber 11 can be reduced.

When a film is formed, two anodes 67 are moved in the directions in which the anodes approach each other by the drive mechanism 71, and each anode 67 and the rear surface WU of the pre-processed substrate W1 are made to abut each other. Moreover, the pre-processed substrate W1 is moved toward the cathode unit 68 so as to be pushed by the anode 67 by driving the drive mechanism 71. Moreover, the heater H is built in the anode 67, and the anode 67 and the heater H constitutes the anode unit 90. For this reason, since nothing is interposed between the anode 67 and the substrate W when a film is formed, the substrate W can be efficiently heated. Additionally, since it becomes unnecessary to separately provide the heater H, the apparatus 10 for manufacturing a thin-film solar cell can be miniaturized.

Additionally, the shower plates 75 and 75 are cathodes (high-frequency electrodes) connected to the matching box 72. Therefore, it becomes unnecessary to separately provide the cathode and the shower plate 75, and it is possible to achieve simplification and lower cost of the apparatus 10 for manufacturing a thin-film solar cell. Additionally, by adopting the shower plate 75 as the cathode, the film forming gas can be uniformly introduced into a film forming area (the inside of the film formation space 81) and a high-frequency voltage can be uniformly applied to the film forming area. Therefore, the plasma becomes more uniform.
Moreover, the film formation space 81 and the space in the chamber in which the carrier and the conveying device exist are separated when the mask 78 and the substrate W abut each other. Moreover, a mating surface (abutting surface) between the mask 78 and the substrate W is constituted as a seal portion 86 so that the film forming gas does not leak out from between the mask 78 and the substrate W. This limits the range where the film forming gas spreads, and can prevent formation of a film to an unnecessary range, that is, the anode 67 or the outer-edge portion of the substrate W. Moreover, since the mask 78 can be separated from the film forming chamber 11 integrally with the electrode unit 31, cleaning of the mask 78 becomes easier. As a result, the operating rate of the apparatus 10 for manufacturing a thin-film solar cell can be improved.

It should be understood that the technical scope of the present invention is not limited to the above-described embodiment, but that various modifications of the above-described embodiments may be made without departing from the scope of the invention. That is, the specific shapes and configurations as set mentioned in the embodiment are merely examples, and can be appropriately changed.
Moreover, the case where the substrates W are respectively arranged on both sides of the cathode unit 68 so as to face the cathode unit 68 in a state where the substrates W become substantially parallel to the vertical direction; the two anodes 67 are arranged outside the respective substrates W in the thickness direction in a state where the anodes 67 face the substrates W, respectively; and the cathode unit 68 is provided with the masks 78 has been described in the above-described embodiment. However, the invention is not limited to this. The substrates W may be respectively arranged on both sides of the anode unit 90 having the anodes 67, a pair of cathode units 68 may be respectively disposed outside the substrates W, and the cathodes 76 may be provided with the masks 78.

### Description of the Reference Symbols

- 10:: APPARATUS FOR MANUFACTURING THIN-FILM SOLAR CELL
- 11:: FILM FORMING CHAMBER
- 21:: CARRIER (CONVEYING PART)
- 59:: HOLDING PORTION
- 59A:: HOLDING PIECE (FIRST HOLDING PIECE)
- 59B:: HOLDING PIECE (SECOND HOLDING PIECE)
- 67:: ANODE
- 68:: CATHODE UNIT
- 71:: DRIVE MECHANISM (DRIVE PART)
- 75:: CATHODE ALSO SERVING AS SHOWER PLATE
- 76:: CATHODE INTERMEDIATE MEMBER
- 78:: MASK
- 79:: DISCHARGE DUCT
- 80:: VACUUMING PORT
- 81:: FILM FORMATION SPACE
- 82:: FLOATING CAPACITANCE MEMBER
- 85:: EXPOSURE SURFACE (PART TO BE EXPOSED)
- 86:: SEAL PORTION
- 102:: TOP CELL (FILM)
- 104:: BOTTOM CELL (FILM)
- H:: HEATER (TEMPERATURE CONTROL SECTION)
- R:: GAS FLOW PASSAGE (EVACUATION PASSAGE)
- W:: SUBSTRATE
- W1: PRE-PROCESSED SUBSTRATE
- W2: POST-PROCESSED SUBSTRATE
- WO:: SURFACE (SURFACE TO BE FILM-FORMED)
- WU:: BACK SURFACE (REAR SURFACE)

## Claims

1. An apparatus (10) for manufacturing a thin film solar cell comprising:
a film forming chamber (11) in which a film is formed on a film formation face (WO) of a substrate (W) using a CVD method;
an electrode unit (31) including a cathode unit (68) having cathodes (75), to which voltages are to be applied, arranged on both sides thereof, and a pair of anodes each of which is arranged to face a different one of the cathodes (75), at a separation distance therefrom;
a mask (78) adapted to cover the peripheral edge portion of the substrate (W); and
a discharge duct (79) installed around the cathode unit (68), wherein:
a film formation space (81) is formed between the cathode unit (68) and the substrate (W) installed on the side of the anode (67);
an evacuation passage (R) is formed between the mask (78) and the cathode unit (68);
the discharge duct (79) and the film formation space (81) are connected together via the evacuation passage (R); and
a film forming gas introduced into the film formation space (81) is evacuated from the discharge duct (79) through the evacuation passage (R), **characterized in that**
the electrode unit (31) further includes a drive part (71) which makes the anode (67) approach or separate from the cathode (75); and
the mask (78) covers the peripheral edge portion of the substrate (W) by moving the anode (67) holding the substrate (W) toward the cathode (75), using the drive part (71); and
the apparatus (10) further comprises:
a conveying part (21) adapted to convey the substrate (W) between the anode (67) and the cathode unit (68), wherein:
the conveying part (21) has a first holding piece (59A) which abuts the film formation face (WO) of the substrate (W), and a second holding piece (59B) which abuts the back surface (WU) of the substrate (W);
the substrate (W) is held by the first holding piece (59A) and the second holding piece (59B);
the first holding piece (59A) is adpated to separate from the second holding piece (59B), when the anode (67) approaches the cathode unit (68)
the first holding piece (59A) is adapted to approach the second holding piece (59B), when the anode (67) separates from the cathode unit (68); and
when the film is formed on the film formation face (WO) of the substrate (W), the peripheral edge portion of the substrate nearer to the inner peripheral side than the first holding piece (59A) of the conveying part (21) is covered with the mask (78).

2. The apparatus (10) for manufacturing a thin-film solar cell according to claim 1, wherein
the cathode (75) is a shower plate which supplies the film forming gas to the film formation face (WO) of the substrate (W).

3. The apparatus (10) for manufacturing a thin-film solar cell according to claim 1, wherein
the space where the film formation space (81) exists, and the space where the conveying part (21) exists are separated from each other as the mask (78) covers the peripheral edge portion of the substrate (W).

4. The apparatus for manufacturing a thin-film solar cell according to anyone of claims 1 to 3, wherein
a temperature control section (H) for adjusting the temperature of the substrate (W) is built into the anode(67).

## Patentansprüche

1. Vorrichtung (10) zum Herstellen einer Dünnfilmsolarzelle, umfassend:
eine Filmbildungskammer (11), in der ein Film auf einer Filmbildungsfläche (WO) eines Substrats (W) unter Verwendung eines CVD-Verfahrens gebildet wird;
eine Elektrodeneinheit (31), die eine Kathodeneinheit (68) beinhaltet, welche an beiden Seiten derselben angeordnete Kathoden (75) aufweist, an die Spannungen anzulegen sind, sowie ein Paar von Anoden, von denen jede so angeordnet ist, dass sie einer anderen der Kathoden (75) gegenübersteht, in einem Trennabstand davon;
eine Maske (78), die angepasst ist, den peripheren Randabschnitt des Substrats (W) abzudecken; und
einen Abführkanal (79), der um die Kathodeneinheit (68) herum installiert ist, wobei:
ein Filmbildungsraum (81) zwischen der Kathodeneinheit (68) und dem Substrat (W), das an der Seite der Anode (67) installiert ist, gebildet ist;
ein Evakuierungsdurchlass (R) zwischen der Maske (78) und der Kathodeneinheit (68) gebildet ist;
der Abführkanal (79) und der Filmbildungsraum (81) über den Evakuierungsdurchlass (R) miteinander verbunden sind; und
ein Filmbildungsgas, das in den Filmbildungsraum (81) eingebracht ist, von dem Abführkanal (79) durch den Evakuierungsdurchlass (R) evakuiert wird, **dadurch gekennzeichnet, dass**
die Elektrodeneinheit (31) des Weiteren ein Antriebsteil (71) beinhaltet, das dafür sorgt, dass die Anode (67) sich der Kathode (75) nähert oder sich von dieser entfernt; und
die Maske (78) den peripheren Randbereich des Substrats (W) abdeckt, indem die Anode (67), die das Substrat (W) hält, in Richtung der Kathode (75) bewegt wird, unter Verwendung des Antriebsteils (71); und
die Vorrichtung (10) des Weiteren umfasst:
ein Überführungsteil (21), das angepasst ist, das Substrat (W) zwischen der Anode (67) und der Kathodeneinheit (68) zu überführen, wobei:
das Überführungsteil (21) ein erstes Haltestück (59A) aufweist, das an der Filmbildungsfläche (WO) des Substrats (W) anliegt, und ein zweites Haltestück (59B), das an der Rückseite (WU) des Substrats (W) anliegt;
wobei das Substrat (W) durch das erste Haltestück (59A) und das zweite Haltestück (59B) gehalten wird;
wobei das erste Haltestück (59A) angepasst ist, sich von dem zweiten Haltestück (59B) zu entfernen, wenn die Anode (67) sich der Kathodeneinheit (68) nähert,
wobei das erste Haltestück (59A) angepasst ist, sich dem zweiten Haltestück (59B) zu nähern, wenn die Anode (67) sich von der Kathodeneinheit (68) entfernt; und
wobei, wenn der Film auf der Filmbildungsfläche (WO) des Substrats (W) gebildet wird, der periphere Randabschnitt des Substrats, der der inneren peripheren Seite näher ist als das erste Haltestück (59A) des Überführungsteils (21), mit der Maske (78) abgedeckt ist.

2. Vorrichtung (10) zum Herstellen einer Dünnfilmsolarzelle gemäß Anspruch 1, wobei
die Kathode (75) eine Brauseplatte ist, die das Filmbildungsgas an der Filmbildungsfläche (WO) des Substrats (W) bereitstellt.

3. Vorrichtung (10) zum Herstellen einer Dünnfilmsolarzelle nach Anspruch 1, wobei
der Raum, wo der Filmbildungsraum (81) existiert, und der Raum, wo das Überführungsteil (21) existiert, voneinander getrennt sind, während die Maske (78) den peripheren Randabschnitt des Substrats (W) abdeckt.

4. Vorrichtung (10) zum Herstellen einer Dünnfilmsolarzelle nach einem der Ansprüche 1 bis 3, wobei
ein Temperatursteuerabschnitt (H) zum Einstellen der Temperatur des Substrats (W) in die Anode (67) eingebaut ist.

## Revendications

1. Dispositif (10) de fabrication d'une cellule solaire en couche mince, comprenant :
une chambre (11) de formation de film dans laquelle un film est formé sur une face (WO) de formation de film d'un substrat (W), en utilisant un procédé CVD ;
une unité (31) d'électrode comprenant une unité (68) de cathode ayant des cathodes (75), auxquelles des tensions doivent être appliquées, montées sur ses deux côtés, et une paire d'anodes, chacune d'entre elles étant montée pour faire face à l'une différente des cathodes (75), en en étant à une distance de séparation ;
un masque (78) conçu pour couvrir la partie de bord périphérique du substrat (W) ; et
un conduit (79) de déchargement monté autour de l'unité (68) de cathode, dans lequel :
un espace (81) de formation d'un film est formé entre l'unité (68) de cathode et le substrat (W) monté du côté de l'anode (67) ;
un passage (R) d'évacuation est formé entre le masque (78) et l'unité (68) de cathode ;
le conduit (79) de déchargement et l'espace (81) de formation d'un film sont reliés ensemble par le passage (R) d'évacuation ; et
un gaz filmogène introduit dans l'espace (81) de formation de film est évacué par le conduit (79) de déchargement, par l'intermédiaire du passage (R) d'évacuation, **caractérisé en ce que**
l'unité (31) d'électrode comprend en outre une partie (71) d'entraînement, qui fait que l'anode (67) se rapproche ou se sépare de la cathode (75) ; et
le masque (78) couvre la partie de bord périphérique du substrat (W) en déplaçant l'anode (67) maintenant le substrat (W) vers la cathode (75), en utilisant la partie (71) d'entraînement ; et
le dispositif (10) comprend en outre :
une partie (21) de convoyage, conçue pour convoyer le substrat (W) entre l'anode (67) et l'unité (68) de cathode, dans lequel :
la partie (21) de convoyage a une première pièce (59A) de maintien qui bute sur la face (WO) de formation de film du substrat (W) et une deuxième pièce (59B) de maintien qui bute sur la surface (WU) arrière du substrat (W) ;
le substrat (W) est maintenu par la première pièce (59A) de maintien et par la deuxième pièce (59B) de maintien ;
la première pièce (59A) de maintien est conçue pour se séparer de la deuxième pièce (59B) de maintien lorsque l'anode (67) se rapproche de l'unité (68) de cathode,
la première pièce (59A) de maintien est conçue pour se rapprocher de la deuxième pièce (59B) de maintien lorsque l'anode (67) se sépare de l'unité (68) de cathode ; et
lorsque le film est formé sur la face (WO) de formation de film du substrat (W), la partie de bord périphérique du substrat, plus proche du côté périphérique intérieur que la première pièce (59A) de maintien de la partie (21) de convoyage, est recouverte du masque (78).

2. Dispositif (10) de fabrication d'une cellule solaire en couche mince suivant la revendication 1, dans lequel
la cathode (75) est une plaque d'arrosage qui fournit le gaz filmogène à la face (WO) de formation de film du substrat (W).

3. Dispositif (10) de fabrication d'une cellule solaire en couche mince suivant la revendication 1, dans lequel
l'espace où l'espace (81) de formation de film existe et l'espace où la partie (21) de convoyage existe sont séparés l'un de l'autre, alors que le masque (78) recouvre la partie de bord périphérique du substrat (W).

4. Dispositif (10) de fabrication d'une cellule solaire en couche mince suivant l'une quelconque des revendications 1 à 3, dans lequel
une section (H) de commande de température pour régler la température du substrat (W) est constituée dans l'anode (67).
